# EUROPEAN PATENT APPLICATION

(11) **EP 1 605 590 A1**
(43) Date of publication of application: **14.12.2005**
(21) Application number: 04713648.6
(22) Date of filing: 23.02.2004
(51) Int. Cl.: H03H 17/06

(54) **DIGITAL FILTER DESIGN METHOD AND DEVICE, DIGITAL FILTER DESIGN PROGRAM, DIGITAL FILTER**

(30) Priority: 03.03.2003 JP 2003056265
(71) Applicant: Neuro Solution Corp., Tokyo 158-0091 (JP)
(72) Inventor: KOYANAGI, Yukio, Saitama-shi, Saitama 3360932 (JP)
(74) Representative: Vossius & Partner
(86) International application number: PCT/JP2004/002070
(87) International publication number: WO 2004/079905

(57) **Abstract**

A numerical string consisting of a ratio of "-1, m, -1" or "1, m, 1" is subjected to a predetermined moving average calculation n times. A numerical string thus obtained is used as filter coefficients of a basic filter and at least one basic filter is combined in an arbitrary way for cascade connection, thereby calculating the filter coefficients of the digital filter to be obtained. This significantly reduces the number of taps and the number of multipliers used as compared to the conventional FIR filter. Moreover, by using the numerical strings "-1, m, -1" and "1, m, 1" so that the filter impulse response becomes a finite-base function, it is possible to obtain a preferable frequency characteristic having no discretization error and having a great attenuation amount out of band.

## Description

### [Background of the Invention]

### [Field of the Invention]

The present invention relates to a digital filter design method and device, digital filter design program, digital filter, and more particularly, to a type of FIR filter which is provided with tapped delay lines made up of a plurality of delayers, multiplies output signals of the respective taps several-fold, adds up the multiplication results and outputs the addition result, and a design method therefor.

### [Description of the Related Art]

An FIR (Finite Impulse Response) filter is one type of digital filter. This FIR filter is a type of filter which is provided with tapped delay lines made up of a plurality of delayers, multiplies output signals of the respective taps several-fold, adds up the multiplication results and outputs the addition result, and has the following advantages. First, since the poles of a transfer function of the FIR filter exists only at the origin of the z-plane, the circuit is always stable. Second, if filter coefficients are symmetric, it is possible to realize a completely accurate rectilinear phase characteristic.

For this FIR filter, an impulse response expressed by a finite time length constitutes filter coefficients as are. Therefore, designing an FIR filter is equal to determining filter coefficients so that a desired frequency characteristic is obtained. Conventionally, an FIR filter is designed using the following method; filter coefficients are calculated based on a target frequency characteristic, the filter coefficients are subjected to windowing and a finite number of coefficient groups are obtained. Then, the coefficient groups obtained are subjected to an FFT (fast Fourier transform) to be transformed to a frequency characteristic and it is checked whether the frequency characteristic satisfies the target characteristic or not.

When filter coefficients are calculated from the target frequency characteristic, for example, a convolution, etc., using a Chebyshev approximation is performed based on a ratio between a sampling frequency and cutoff frequency. The number of coefficients obtained in this way becomes enormous and using all those coefficients will result in an extremely large number of taps and multipliers of the filter circuit, which is unrealistic. For this reason, it is necessary to reduce the number of filter coefficients to a degree that it falls within a range of practicality by means of windowing.

However, the frequency characteristic of the FIR filter obtained using the conventional design method depends on a window function and approximate expression, and therefore unless these are correctly set, it is not possible to obtain a preferable target frequency characteristic. However, it is generally difficult to set the window function or approximate expression appropriately. Furthermore, performing windowing to reduce the number of filter coefficients causes a discretization error in the frequency characteristic. For this reason, there has been a problem that it is very difficult to realize a desired frequency characteristic using the conventional filter design method.

Furthermore, obtaining a desired frequency characteristic using the conventional filter design method requires a trial and error method of subjecting the filter coefficients obtained to an FFT while checking the frequency characteristic. Thus, the conventional art requires skilled technicians to take time and trouble its design for and has a problem that it is not easy to design an FIR filter of a desired characteristic easily.

Furthermore, in designing an FIR filter capable of realizing a desired frequency characteristic as accurately as possible, there is a limit to the number of filter coefficients that can be reduced by windowing. For this reason, the number of taps of the designed FIR filter becomes enormous and its filter coefficient values become very complicated and random values. Thus, there is also a problem that realizing such a number of taps and filter coefficient values requires a large-scale circuit structure (adders, multipliers).

In this regard, a method of adjusting a filter bank band by inserting at least one zero value between taps (between filter coefficients) of tapped delay lines is known (for example, see National Publication of International Patent Application No. 6-503450). Furthermore, a method of realizing a steep frequency characteristic by cascade connecting a plurality of FIR filters is also known (for example, see Japanese Patent Laid-Open No. 5-243908). However, even using one of these methods can only narrow the pass band of the filter and cannot realize a frequency characteristic of an arbitrary shape with a small number of taps.

### [Summary of the Invention]

The present invention has been implemented to solve the above described problems and it is an object of the present invention to enable an FIR digital filter having a desired frequency characteristic to be designed easily.

Furthermore, it is another object of the present invention to realize an FIR digital filter having a desired frequency characteristic on a small circuit scale and with high accuracy.

In order to solve the above described problems, the present invention uses a numerical string obtained by subjecting a numerical string consisting of a ratio of "-1, m, -1" or "1, m, 1" to a predetermined moving average calculation n times as filter coefficients of basic filters and combines at least one basic filter in an arbitrary way for cascade connection to thereby calculate the filter coefficients of the digital filter to be obtained.

The present invention having such a structure can significantly reduce the number of taps and the number of multipliers used as compared to the conventional FIR filter and make the structure of the digital filter extremely simple. Furthermore, windowing for reducing the number of filter coefficients no longer needs to be performed and the filter impulse response also becomes a finite-base function, and therefore it is possible to obtain a preferable frequency characteristic having no discretization error and having a great attenuation amount out of band. Therefore, it is possible to realize an FIR digital filter having a desired frequency characteristic on a small circuit scale and with high accuracy. Furthermore, the present invention allows a desired digital filter to be constructed by only combining basic filters and allows even non-skilled technicians to design an FIR digital filter having a desired frequency characteristic extremely simply.

### [Brief Description of the Drawings]

Figure 1 illustrates filter coefficients of a basic low pass filter L4an;
Figure 2 illustrates a frequency characteristic of a basic low pass filter L4a4;
Figure 3A and 3B illustrate frequency-gain characteristics of the basic low pass filter L4an;
Figure 4 illustrates filter coefficients of a basic low pass filter Lan;
Figure 5 illustrates a frequency characteristic of a basic low pass filter La4;
Figure 6A and 6B illustrate frequency-gain characteristics of the basic low pass filter Lan;
Figure 7 illustrates filter coefficients of a basic high pass filter H4sn.
Figure 8 illustrates a frequency characteristic of a basic high pass filter H4s4;
Figure 9A and 9B illustrate frequency-gain characteristics of the basic high pass filter H4sn;
Figure 10 illustrates filter coefficients of a basic high pass filter Hsn;
Figure 11 illustrates a frequency characteristic of a basic high pass filter Hs4;
Figure 12A and 12B illustrate frequency-gain characteristics of the basic high pass filter Hsn;
Figure 13 illustrates filter coefficients of a basic band pass filter B4sn;
Figure 14 illustrates a frequency characteristic of a basic band pass filter B4s4;
Figure 15A and 15B illustrate frequency-gain characteristics of the basic band pass filter B4sn;
Figure 16 illustrates filter coefficients of a basic band pass filter Bsn;
Figure 17 illustrates a frequency characteristic of a basic band pass filter Bs4;
Figure 18A and 18B illustrate frequency-gain characteristics of the basic band pass filter Bsn;
Figure 19 illustrates a frequency-gain characteristic of a basic high pass filter Hmsn using m as a parameter;
Figure 20 illustrates an optimal value of parameter n with respect to parameter m;
Figure 21 illustrates a relationship between parameter m and an optimal value of corresponding parameter n and a relationship between parameter m and corresponding parameter x;
Figure 22 illustrates impulse responses of the basic high pass filter Hmsn;
Figure 23A and 23B illustrate frequency-gain characteristics of basic low pass filters L4a4, L4a4 (1);
Figure 24 illustrates calculation contents of filter coefficients when basic filters are cascade connected;
Figure 25A and 25B illustrate frequency-gain characteristics of a basic low pass filter (L4a4)^{M};
Figure 26A and 26B illustrate frequency-gain characteristics of a basic high pass filter (H4s4)^{M};
Figure 27 is a graph showing filter coefficient values actually calculated with 16-bit calculation accuracy (before rounding);
Figure 28A and 28B illustrate frequency characteristics of a digital filter before filter coefficients are subjected to rounding;
Figure 29 illustrates filter coefficient values corresponding to 41 taps (the number of stages including a zero value is 46) which remain as a result of 10-bit rounding applied to the filter coefficients in Figure 27 and coefficient values which are the filter coefficients rounded to integers;
Figure 30A and 30B illustrate frequency-gain characteristics after filter coefficients are calculated with 16-bit calculation accuracy and then rounded to 10-bit integers;
Figure 31 illustrates an example of the hardware structure of the basic low pass filter L4a4;
Figure 32 illustrates an example of the hardware structure of the basic low pass filter La4;
Figure 33 illustrates an example of the hardware structure of the basic high pass filter H4s4;
Figure 34 illustrates an example of the hardware structure of the basic high pass filter Hs4;
Figure 35 illustrates an example of the hardware structure of the basic band pass filter B4s4;
Figure 36 illustrates an example of the hardware structure of the basic band pass filter Bs4;
Figure 37 illustrates an example of the structure of a band pass filter;
Figure 38A to 38C illustrate frequency characteristics of the band pass filter shown in Figure 37;
Figure 39 illustrates another example of the structure of the band pass filter; and
Figure 40A to 40C illustrate frequency-gain characteristics of the band pass filter shown in Figure 39.

### [Detailed Description of the Preferred Embodiments]

With reference now to the attached drawings, an embodiment of the present invention will be explained below. Noting an aspect that a convolution of impulse responses corresponds to summation of frequency responses in the impulse response on the time axis and a frequency characteristic on the frequency axis correlating with each other, this embodiment provides a completely new filter design method which is fundamentally different from a conventional design method which takes a calculation of filter coefficients as a starting point, and a digital filter which is a product thereof.

That is, this embodiment defines several types of basic filters having specific impulse responses and realizes an FIR filter having a desired frequency characteristic in the form of cascade connecting the basic filters in an arbitrary way. The basic filters can be roughly divided into three types; basic low pass filter, basic high pass filter and basic band pass filter (including a comb-shaped filter). These basic filters will be explained below.

### <Basic low pass filter Lman (m, n are variables, n is a natural number)>

The filter coefficients of a basic low pass filter Lman can be obtained through a moving average calculation by sequentially adding up original data before the calculation and preceding data which is ahead thereof by a predetermined amount of delay taking a numerical string "-1, m, -1" as a starting point.

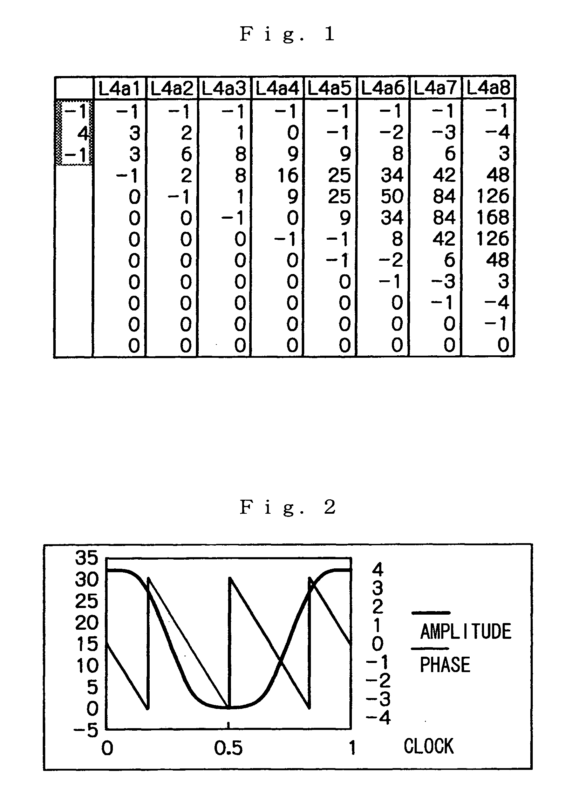

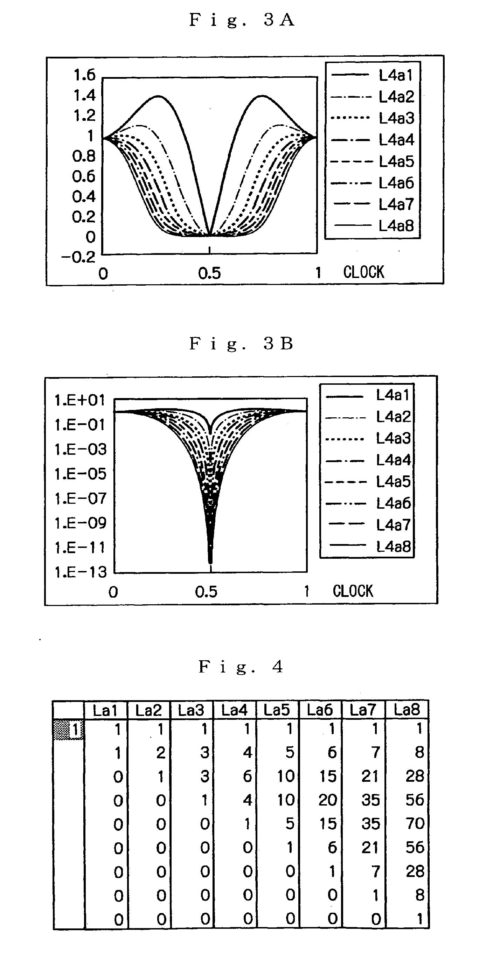

Figure 1 illustrates filter coefficients of a basic low pass filter L4an (when m=4). In Figure 1, in obtaining a jth filter coefficient from top of the nth column by a moving average calculation, the "original data" refers to the jth data from top of the (n-1)th column. On the other hand, the "preceding data" refers to the (j-1)th data from top of the (n-1)th column.

For example, the first numerical value "-1" from top of the basic lowpass filter L4a1 is obtained by adding the original data "-1" to the preceding data "0", the second numerical value "3" is obtained by adding the original data "4" to the preceding data "-1." Furthermore, the third numerical value "3" is obtained by adding the original data "-1" to the preceding data "4" and the fourth numerical value "-1" is obtained by adding the original data "0" to the preceding data "-1."

Filter coefficients of any basic low pass filter L4an shown in Figure 1 consist of a symmetric numerical string characterized in that the sums of every other value have the same sign and the same value (e.g., in the case of the basic low pass filter L4a4, -1+9+9+(-1)=16, 0+16+0=16).

The above described numerical string "-1, m, -1" is generated based on a basic numerical string "-1, N." A basic unit filter having this numerical string "-1, N" as filter coefficients has 1 or 2 (1 when N=0, and 2 otherwise) taps. The value of N need not necessarily be an integer.

Since the basic unit filter having this numerical string "-1, N" as filter coefficients is asymmetric, changing it to a symmetric type requires a plurality of basic unit filters to be cascade connected for use. For example, when two basic unit filters are cascade connected, the filter coefficients become "-N, N²+1, -N" as a result of a convolution of the numerical string "-1, N." Here, assuming that (N²+1)/N=m, where m is an integer, N=(m+(m²-4)^{1/2})/2.

When m=4 as shown in the example of Figure 1, N=2+√3. That is, the coefficients of the basic unit filter become "-1, 3.732" (here, up to three decimal places are shown). Furthermore, the filter coefficients when two basic unit filters are cascade connected become "-3.732, 14.928, -3.732." This numerical string has a relationship of -1:4:-1.

When this numerical string is actually used as filter coefficients, each value of the numerical string is divided by 2N (=2*(2+√3)=7.464) so that the amplitude when the numerical string of the filter coefficients is subjected to an FFT transform becomes "1" and the gain is normalized to "1" (normalization). That is, the numerical string of the filter coefficients to be actually used becomes "-1/2, 2, -1/2." This numerical string to be actually used "-1/2, 2, -1/2" corresponds to the original numerical string "-1, 4, -1" multiplied by z times (z=1/(m-2)).

When the numerical string normalized as shown above is used as filter coefficients, the filter coefficients of the basic low pass filter Lman are characterized in that the sum total of the numerical string is "1" and the total values of every other value of the numerical string have the same sign and the same value.

Figure 2 shows a frequency characteristic (frequency-gain characteristic and frequency-phase characteristic) obtained by FFT transforming the numerical string of the filter coefficients of the basic low pass filter L4a4 (when m=4, n=4). Here, the gain is expressed on a straight scale and the normalized gain is multiplied 32-fold. On the other hand, the frequency is normalized with "1."

As is appreciated from this Figure 2, a frequency-gain characteristic with a substantially flat pass band and a cut-off area with a gentle inclination is obtained. Furthermore, a substantially rectilinear frequency-phase characteristic is also obtained. Thus, the basic low pass filter L4a4 can obtain a preferable low pass filter frequency characteristic with no overshoot or ringing.

Figure 3A and 3B illustrate frequency-gain characteristics of a basic low pass filter L4an using n as a parameter, Figure 3A expresses the gain on a straight scale and Figure 3B expresses the gain on a logarithmic scale. From this Figure 3, it is appreciated that the inclination of the cut-off area becomes steeper as the value of n increases. This basic low pass filter L4an is suitable for use in a relatively steep frequency characteristic when n≥5 and suitable for use in a relatively gentle frequency characteristic when n<5.

Figure 4 illustrates filter coefficients of a basic low pass filter Lan when N=0 is assumed in a numerical string "-1, N" of the basic unit filter. When N=0, the filter coefficients when two basic unit filters are cascade connected become "0, 1, 0." Therefore, the filter coefficient of the basic low pass filter Lan can be obtained through a moving average calculation by sequentially adding up original data and preceding data taking "1" as a starting point.

The filter coefficients of any basic low pass filter Lan shown in Figure 4 have a symmetric numerical string and are characterized in that the total values of every other value of the numerical string have the same sign and the same value (e.g., in the case of a basic low pass filter La4, 1+6+1=8, 4+4=8).

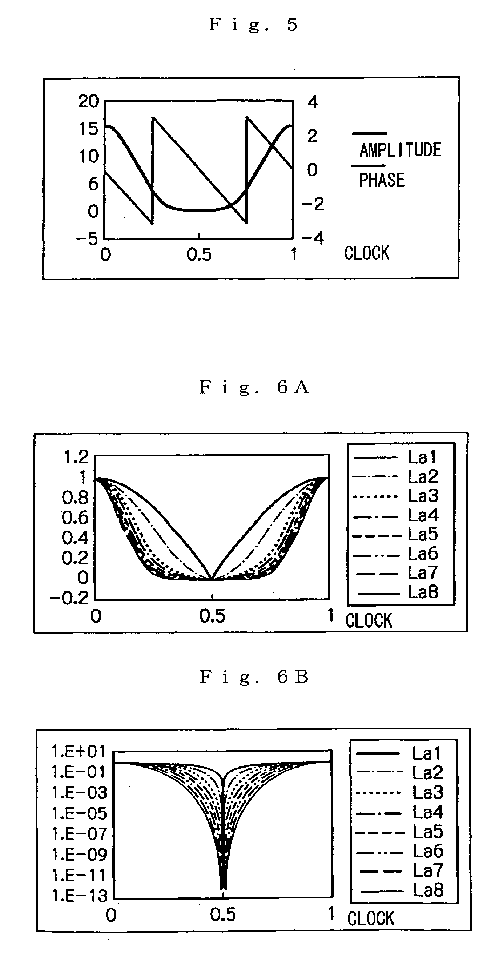

Figure 5 illustrates a frequency characteristic obtained by FFT transforming a numerical string consisting of filter coefficients of a basic low pass filter La4. Here, the gain is expressed on a straight scale and the normalized gain is multiplied 16-fold. On the other hand, the frequency is normalized with "1."

As is appreciated from this Figure 5, the substantially flat pass band in the frequency-gain characteristic is narrower than that in Figure 2, but a cut-off area with a gentle inclination is obtained. Furthermore, with regard to the frequency-phase characteristic, a substantially rectilinear characteristic is also obtained. Thus, the basic low pass filter La4 can also obtain a preferable low pass filter frequency characteristic with no overshoot or ringing.

Figure 6A and 6B illustrate frequency-gain characteristics of a basic low pass filter Lan using n as a parameter, Figure 6A expresses the gain on a straight scale and Figure 6B expresses the gain on a logarithmic scale. From this Figure 6, it is appreciated that the inclination of the cut-off area becomes steeper as the value of n increases. This basic low pass filter Lan is suitable for use in a relatively steep frequency characteristic when n≥5 and suitable for use in a relatively gentle frequency characteristic when n<5.

### <Basic high pass filter Hmsn (where m, n are variable, n is a natural number)>

The filter coefficients of a basic high pass filter Hmsn can be obtained through a moving average calculation by sequentially subtracting preceding data ahead of original data by a predetermined amount of delay from the original data before the calculation taking a numerical string "1, m, 1" as a starting point.

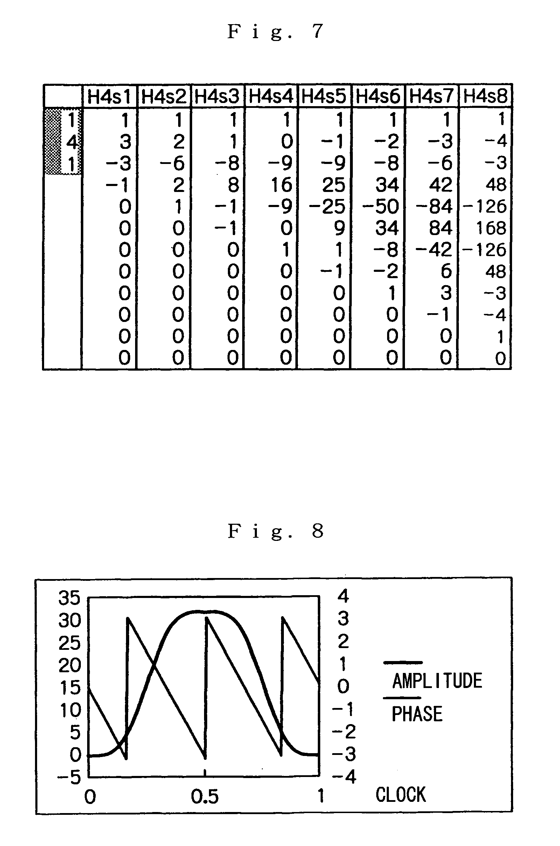

Figure 7 illustrates filter coefficients of a basic high pass filter H4sn (when m=4). In Figure 7, in obtaining the jth filter coefficient from top of the nth column through a moving average calculation, the "original data" refers to the jth data from top of the (n-1)th column. Furthermore, the "preceding data" refers to the (j-1)th data from top of the (n-1)th column.

For example, the first numerical value "1" from top of a basic high pass filter H4s1 is obtained by subtracting preceding data "0" from original data "1" and the second numerical value "3" is obtained by subtracting preceding data "1" from original data "4." Furthermore, the third numerical value "-3" is obtained by subtracting preceding data "4" from original data "1" and the fourth numerical value "-1" is obtained by subtracting preceding data "1" from original data "0."

In a basic high pass filter H4sn shown in Figure 7, when n is an even number, filter coefficients of any numerical string are symmetric and are characterized in that the total values of every other value of the numerical string have opposite signs and the same value (for example, in the case of a basic high pass filter H4s4, 1+(-9)+(-9)+1=-16, 0+16+0=16). When n is an odd number, the absolute values of the numerical string are symmetric and the first half numerical string and the second half numerical string have opposite signs. Furthermore, the filter coefficients are characterized in that the total values of every other value of the numerical string have the opposite signs and the same value.

The above described numerical string "1, m, 1" is generated based on a basic numerical string "1, N. " The basic unit filter using this numerical string "1, N" as filter coefficients has 1 or 2 taps (1 tap when N=0, 2 taps otherwise). Here, the value of N need not always be an integer.

Since the basic unit filter having this numerical string "1, N" as filter coefficients is asymmetric, changing it to a symmetric type requires a plurality of basic unit filters to be cascade connected for use. For example, when two basic unit filters are cascade connected, the filter coefficients become "N, N²+1, N" as a result of a convolution of the numerical string "1, N." Here, assuming that (N²+1)/N=m, where m is an integer, N=(m+(m²-4)^{1/2})/2.

When m=4 as shown in the example of Figure 7, N=2+√3. That is, the coefficients of the basic unit filter become "1, 3.732" (here, up to three decimal places are shown). Furthermore, the filter coefficients when two basic unit filters are cascade connected become "3.732, 14.928, 3.732." This numerical string has a relationship of 1:4:1.

When this numerical string is actually used as filter coefficients, each value of the numerical string is divided by 2N (=2*(2+√3)=7.464) so that the amplitude when the numerical string of the filter coefficients is subjected to an FFT transform becomes "1" and the gain is normalized to "1." That is, the numerical string of filter coefficients to be actually used becomes "1/2, 2, 1/2." This numerical string to be actually used "1/2, 2, 1/2" also corresponds to the original numerical string "1, 4, 1" multiplied by z times (z=1/(m-2)).

When the numerical string normalized as shown above is used as filter coefficients, the filter coefficients of the basic high pass filter Hmsn are characterized in that the sum total of the numerical string is "0" and the total values of every other value of the numerical string have the opposite signs and the same value.

Figure 8 illustrates a frequency characteristic obtained by FFT transforming the numerical string of filter coefficients of the basic high pass filter H4s4 (when m=4, n=4). Here, the gain is expressed on a straight scale and the normalized gain is multiplied 32-fold. On the other hand, the frequency is normalized with "1."

As is evident from this Figure 8, it is possible to obtain a frequency-gain characteristic having a substantially flat pass band and a cut-off area with a gentle inclination. Furthermore, a substantially rectilinear frequency-phase characteristic is also obtained. Thus, the basic high pass filter H4s4 can obtain a preferable high pass filter frequency characteristic with no overshoot or ringing.

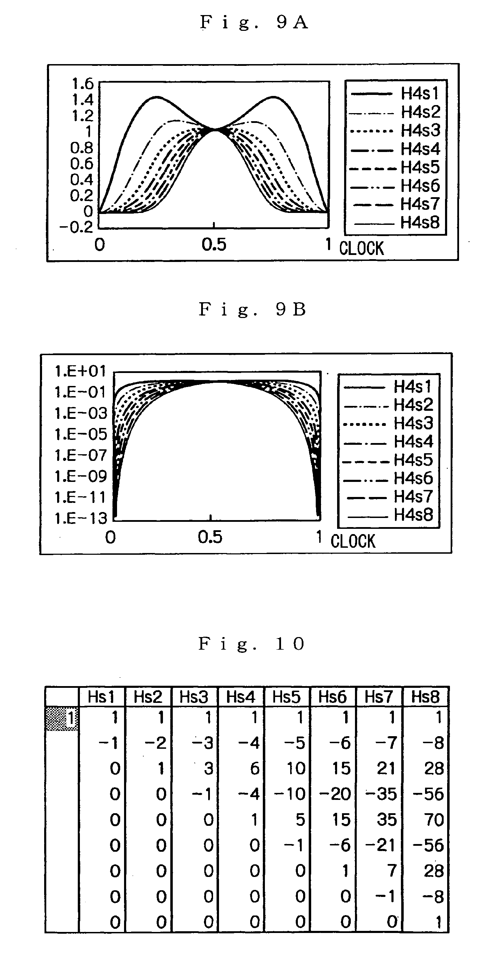

Figure 9A and 9B illustrate frequency-gain characteristics of a basic high pass filter H4sn using n as a parameter, Figure 9A expresses the gain on a straight scale and Figure 9B expresses the gain on a logarithmic scale. From this Figure 9, it is appreciated that the inclination of the cut-off area becomes steeper as the value of n increases. This basic high pass filter H4sn is suitable for use in a relatively steep frequency characteristic when n≥5 and suitable for use in a relatively gentle frequency characteristic when n<5.

Figure 10 illustrates filter coefficients of a basic high pass filter Hsn when N=0 is assumed in the basic unit filter numerical string "1, N." When N=0, the filter coefficients when two basic unit filters are cascade connected are "0, 1, 0." Therefore, filter coefficients of the basic high pass filter Hsn can be obtained through a moving average calculation by sequentially subtracting preceding data from original data and taking "1" as a starting point.

In the basic high pass filter Hsn shown in Figure 10, when n is an even number, filter coefficients of any numerical string are symmetric and are characterized in that the total values of every other value of the numerical string have opposite signs and the same value (for example, in the case of a basic high pass filter Hs4, 1+6+1=8, -4+(-4)=-8). When n is an odd number, the absolute values of the numerical string are symmetric and the first half numerical string and the second half numerical string have opposite signs. Furthermore, the filter coefficients are characterized in that the total values of every other value of the numerical string have the opposite signs and the same value.

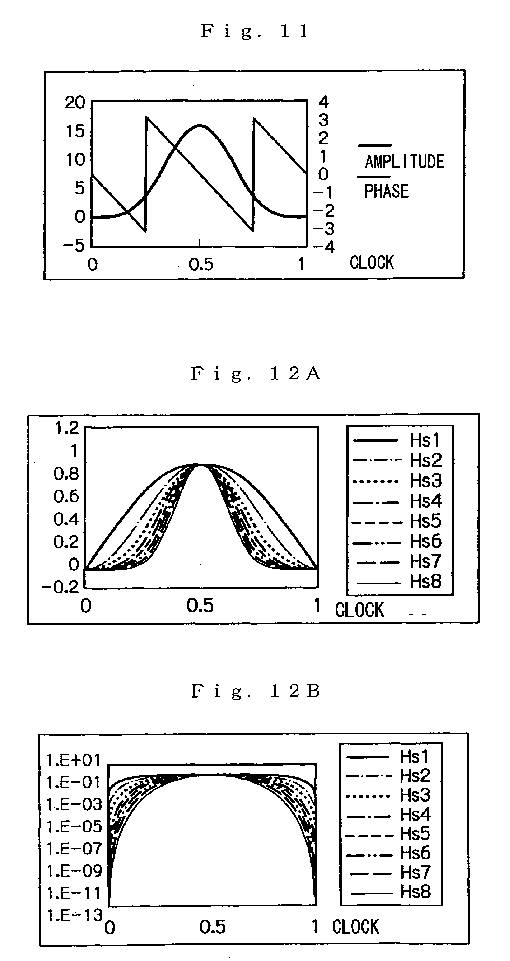

Figure 11 illustrates a frequency characteristic obtained by FFT transforming the numerical string of filter coefficients of the basic high pass filter Hs4. Here, the gain is expressed on a straight scale and the normalized gain is multiplied 16-fold. On the other hand, the frequency is normalized with "1."

As is evident from this Figure 11, it is possible to obtain a frequency-gain characteristic having a substantially flat pass band which is yet narrower than that in Figure 8 and a cut-off area with a gentle inclination. Furthermore, a substantially rectilinear frequency-phase characteristic is also obtained. Thus, the basic high pass filter Hs4 can obtain a preferable high pass filter frequency characteristic with no overshoot or ringing.

Figure 12A and 12B illustrate frequency-gain characteristics of a basic high pass filter Hsn using n as a parameter, Figure 12A expresses the gain on a straight scale and Figure 12B expresses the gain on a logarithmic scale. From this Figure 12, it is appreciated that the inclination of the cut-off area becomes steeper as the value of n increases. This basic high pass filter Hsn is suitable for use in a relatively steep frequency characteristic when n≥5 and suitable for use in a relatively gentle frequency characteristic when n<5.

### <Basic band pass filter Bmsn (where m, n are variables, n is a natural number)>

Filter coefficients of a basic band pass filter Bmsn can be obtained through a moving average calculation by sequentially subtracting second preceding data from original data by taking numerical string "1, 0, m, 0, 1" as a starting point.

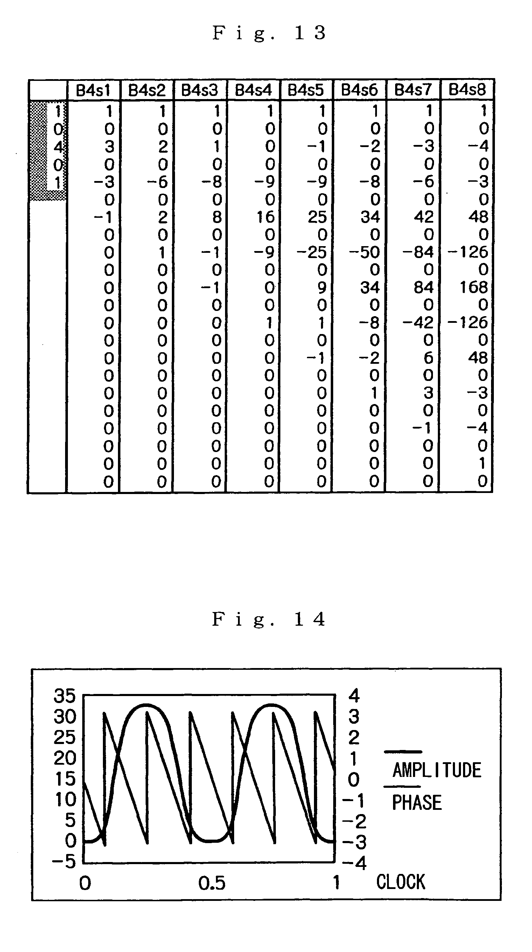

Figure 13 illustrates filter coefficients of a basic band pass filter B4sn (when m=4). In Figure 13, in obtaining the jth filter coefficient from top of the nth column through a moving average calculation, the "original data" refers to the jth data from top of the (n-1)th column. Furthermore, the "preceding data" refers to the (j-2)th data from top of the (n-1)th column.

For example, the first numerical value "1" from top of a basic band pass filter B4s1 is obtained by subtracting preceding data "0" from original data "1" and the third numerical value "3" is obtained by subtracting preceding data "1" from original data "4." Furthermore, the fifth numerical value "-3" is obtained by subtracting preceding data "4" from original data "1" and the seventh numerical value "-1" is obtained by subtracting preceding data "1" from original data "0."

In a basic band pass filter B4sn shown in Figure 13, when n is an even number, filter coefficients of any numerical string are symmetric and are characterized in that the total values of every three values of the numerical string have opposite signs and the same value (for example, in the case of a basic band pass filter B4s4, 1+(-9)+(-9)+1=-16, 0+16+0=16). When n is an odd number, the absolute values of the numerical string are symmetric and the first half numerical string and the second half numerical string have opposite signs. Furthermore, the filter coefficients are characterized in that the total values of every three values of the numerical string have the opposite signs and the same value.

The above described numerical string "1, 0, m, 0, 1" is generated based on the basic numerical string "1, 0, N." The basic unit filter using this numerical string "1, 0, N" as filter coefficients has 1 to 2 taps (1 tap when N=0, otherwise 2 taps). Here, the value of N need not always be an integer.

Since the basic unit filter having this numerical string "1, 0, N" as filter coefficients is asymmetric, changing it to a symmetric type requires a plurality of basic unit filters to be cascade connected for use. For example, when two basic unit filters are cascade connected, the filter coefficients become "N, 0, N²+1, 0, N" as a result of a convolution of the numerical string "1, 0, N." Here, assuming that (N²+1)/N=m, where m is an integer, N=(m+(m²-4)^{1/2})/2.

When m=4 as shown in the example of Figure 13, N=2+√3. That is, the coefficients of the basic unit filter become "1, 0, 3.732" (here, up to three decimal places are shown). Furthermore, the filter coefficients when two basic unit filters are cascade connected become "3.732, 0, 14.928, 0, 3.732." This numerical string has a relationship of 1:0:4:0:1.

When this numerical string is actually used as filter coefficients, each value of the numerical string is divided by 2N (=2*(2+√3)=7.464) so that the amplitude when the numerical string of the filter coefficients is subjected to an FFT transform becomes "1" and the gain is normalized to "1." That is, the numerical string of the filter coefficients to be actually used becomes "1/2, 0, 2, 0, 1/2." This numerical string to be actually used "1/2, 0, 2, 0, 1/2" also corresponds to the original numerical string "1, 0, 4, 0, 1" multiplied by z times (z=1/(m-2)).

When the numerical string normalized as shown above is used as the filter coefficients, the filter coefficients of the basic band pass filter Bmsn are characterized in that the sum total of the numerical string is "0" and the total values of every three values of the numerical string have the opposite signs and the same value.

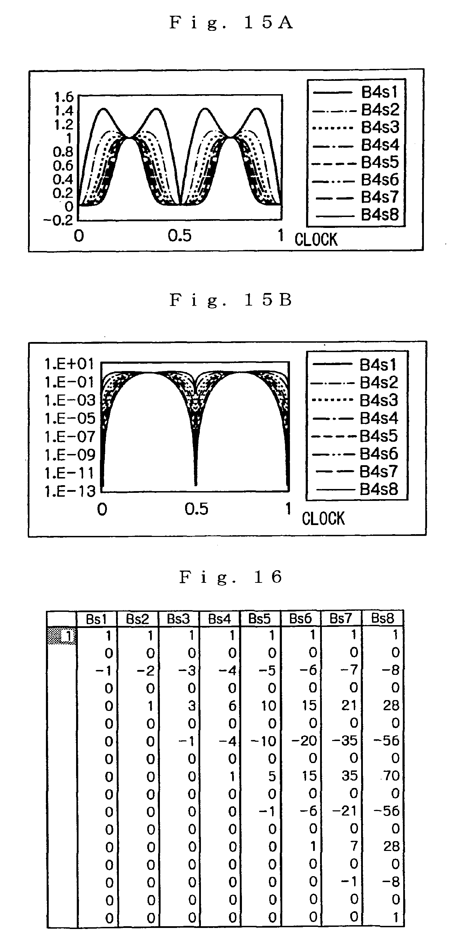

Figure 14 illustrates a frequency characteristic obtained by FFT transforming the numerical string of the filter coefficients of the basic band pass filter B4s4 (when m=4, n=4). Here, the gain is expressed on a straight scale and the normalized gain is multiplied 32-fold. On the other hand, the frequency is normalized with "1."

As is appreciated from this Figure 14, it is possible to obtain a frequency-gain characteristic having a substantially flat pass band and a cut-off area with a gentle inclination. Furthermore, a substantially rectilinear frequency-phase characteristic is also obtained. Thus, the basic band pass filter B4s4 can obtain a preferable band pass filter frequency characteristic with no overshoot or ringing.

Figure 15A and 15B illustrate frequency-gain characteristics of a basic band pass filter B4sn using n as a parameter, Figure 15A expresses the gain on a straight scale and Figure 15B expresses the gain on a logarithmic scale. From this Figure 15, it is appreciated that the inclination of the cut-off area becomes steeper as the value of n increases. This basic band pass filter B4sn is suitable for use in a relatively steep frequency characteristic when n≥5 and suitable for use in a relatively gentle frequency characteristic when n<5.

Figure 16 illustrates filter coefficients of a basic band pass filter Bsn when N=0 is assumed in a numerical string "1, 0, N" of the basic unit filter. When N=0, the filter coefficients when two basic unit filters are cascade connected are "0, 0, 1, 0, 0." Therefore, filter coefficients of the basic band pass filter Bsn can be obtained through a moving average calculation by sequentially subtracting second preceding data from original data by taking "1" as a starting point.

In a basic band pass filter Bsn shown in Figure 16, when n is an even number, a numerical string of any filter coefficients is symmetric and is characterized in that the total values of every three values of the numerical string have opposite signs and the same value (for example, in the case of a basic band pass filter Bs4, 1+6+1=8,-4+(-4)=-8). When n is an odd number, the absolute values of the numerical string are symmetric and the first half numerical string and the second half numerical string have opposite signs. Furthermore, the filter coefficients are characterized in that the total values of every three values of the numerical string have the opposite signs and the same value.

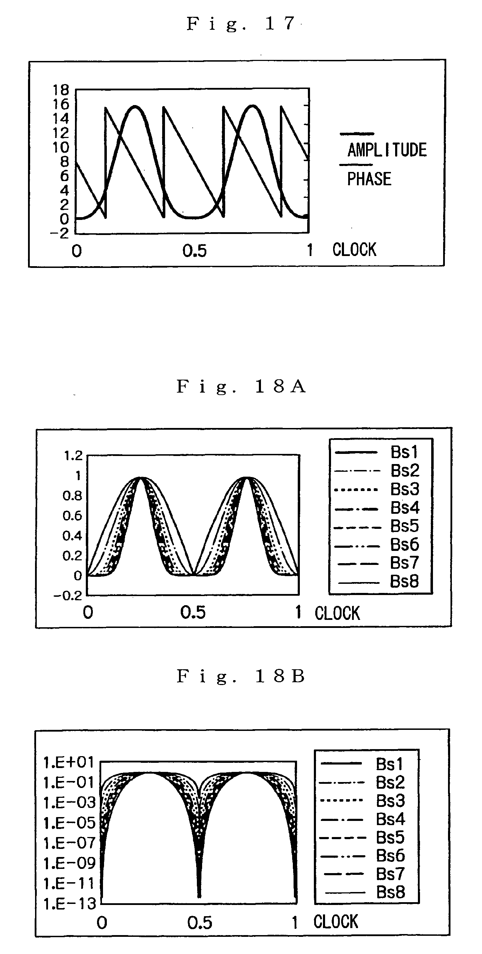

Figure 17 illustrates a frequency characteristic obtained by FFT transforming the numerical string of filter coefficients of the basic band pass filter Bs4. Here, the gain is expressed on a straight scale and the normalized gain is multiplied 16-fold. On the other hand, the frequency is normalized with "1."

As is appreciated from this Figure 17, it is possible to obtain a frequency-gain characteristic having a substantially flat pass band which is yet narrower than that in Figure 14 and a cut-off area with a gentle inclination. Furthermore, a substantially rectilinear frequency-phase characteristic is also obtained. Thus, the basic band pass filter Bs4 can obtain a preferable band pass filter frequency characteristic with no overshoot or ringing.

Figure 18A and 18B illustrate frequency-gain characteristics of a basic band pass filter Bsn using n as a parameter, Figure 18A expresses the gain on a straight scale and Figure 18B expresses the gain on a logarithmic scale. From this Figure 18, it is appreciated that the inclination of the cut-off area becomes steeper as the value of n increases. This basic band pass filter Bsn is suitable for use in a relatively steep frequency characteristic when n≥5 and suitable for use in a relatively gentle frequency characteristic when n<5.

### <Influence of parameter values m, n on characteristic >

First, an influence when the number of stages n of a moving average calculation is changed will be explained. For example, as shown in Figure 3, when the value of n is increased in a basic low pass filter Lman, inclination of the cut-off area becomes steeper and the bandwidth of a pass band becomes narrower. Furthermore, when the value of n is small, both ends of a vertex of the frequency characteristic rise. As the value of n increases, the vertex gradually flattens and becomes completely flat when n=4. When the value of n exceeds the value, then both ends of the vertex fall below the central value. Such a tendency also applies to a basic high pass filter Hmsn and basic band pass filter Bmsn (see Figure 9, Figure 15).

On the other hand, with regard to a basic low pass filter Lan, basic high pass filter Hsn and basic band pass filter Bsn with the coefficient values of the basic unit filter set to N=0, both ends of the vertex fall below the central value no matter what the value of n may be as shown in Figure 6, Figure 12 and Figure 18. When the value of n is increased, the inclination of the cut-off area becomes steeper and the bandwidth of the pass band becomes narrower as in the case of the basic low pass filter Lman, basic high pass filter Hmsn and basic band pass filter Bmsn with N≠0.

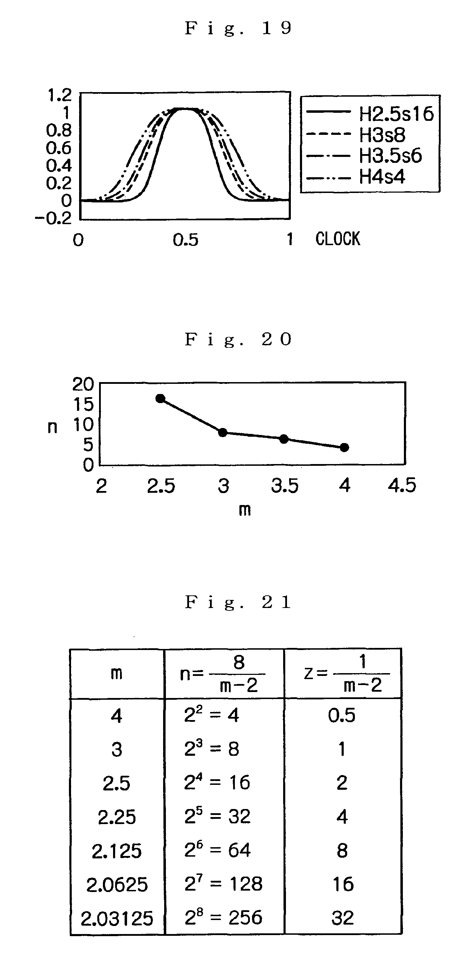

Next, influences when the value of m is changed will be explained. Figure 19 illustrates a frequency-gain characteristic of the basic high pass filter Hmsn using m as a parameter. From this Figure 19, it is appreciated that the inclination of the cut-off area becomes steeper when the value of m is decreased and the bandwidth of the pass band becomes narrower. Though not shown here, the same applies to the basic low pass filter Lman and basic band pass filter Bmsn.

This Figure 19 also shows an optimal value of parameter n with respect to parameter m (the value of n when the vertex of the frequency characteristic becomes flat) simultaneously. That is, the optimal value when m=4 is n=4, the optimal value when m=3.5 is n=6, the optimal value when m=3 is n=8, and the optimal value when m=2.5 is n=16. Figure 20 shows this clearly in the form of a graph. As is clear from this Figure 20, the optimal value of parameter n with respect to parameter m increases as the value of m decreases.

This will be explained in more detail using Figure 21. Figure 21 illustrates a relationship between parameter m and an optimal value of corresponding parameter n in the form of a table. This Figure 21 also shows a relationship between parameter m and parameter x.

As described above, the optimal value of parameter n with respect to parameter m increases as the value of m decreases. Here, when m=2, the filter characteristic changes a great deal and a preferable frequency characteristic can no longer be obtained. To put it the other way around, under a condition of m>2, it is possible to obtain a preferable filter characteristic with a narrow bandwidth in the pass band even when the amount of delay to be inserted between taps is not increased. On the other hand, as the value of parameter m increases, the optimal value of parameter n decreases and n=1 when m=10. That is, when m=10, the number of stages of a moving average calculation can be only one. From this, parameter m is preferably used under a condition of 2<m≤10.

Furthermore, for the value of parameter n, it is possible to adjust the frequency characteristic as shown in Figure 3, Figure 9, and Figure 15 using an arbitrary value selected from a range before and after the optimal value shown in Figure 21 as a center.

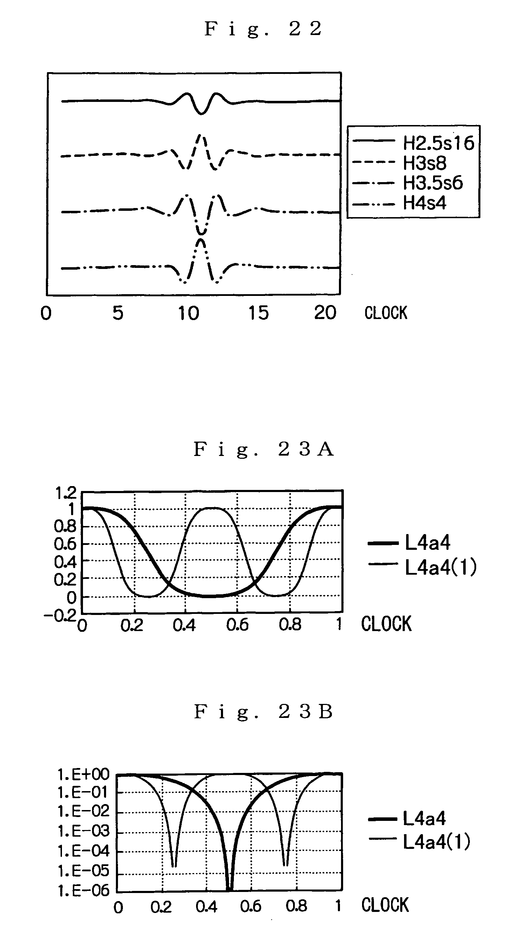

Figure 22 illustrates impulse responses of four types of the basic high pass filter Hmsn shown in Figure 19. The impulse response having the waveform shown in this Figure 22 is a function which has a finite value other than "0" only when the sample position along the horizontal axis is within a certain section and all values in other areas become "0", that is, a function whose value at a predetermined sample position converges to "0."

In this way, the case where a value of a function has a finite value other than "0" in a local area and becomes "0" in other areas is called "finite base ." Though not shown, an impulse response likewise becomes finite base for a basic high pass filter Hsn, basic low pass filters Lman, Lan and basic band pass filters Bmsn, Bsn.

In such a finite-base impulse response, only data in a local area having a finite value other than "0" has a meaning. It is not because data outside this area which originally should be considered is ignored but because the data need not be considered theoretically, and therefore no discretization error occurs. Therefore, if the numerical strings shown in Figure 1, Figure 4, Figure 7, Figure 10, Figure 13 and Figure 16 are used as filter coefficients, it is not necessary to discretize coefficients through windowing and it is possible to obtain a preferable filter characteristic.

### <Adjustment of zero values between filter coefficients >

By changing a zero value (corresponding to an amount of delay between taps) between numerical values of a numerical string that makes up filter coefficients of a basic filter, it is possible to adjust the bandwidth of the pass band of the basic filter. That is, in the above described basic low pass filters Lman, Lan, basic high pass filters Hmsn, Hsn and basic band pass filters Bmsn, Bsn, the amount of delay between taps is 1 clock, but if this is assumed to be (k+1) clocks (k "0s" are inserted between filter coefficients), the frequency axis of the frequency-gain characteristic (period with respect to the frequency direction) becomes 1/(k+1) and the bandwidth of the pass band becomes narrower. Suppose the case where k "0s" are inserted between filter coefficients of, for example, the basic low pass filter Lman is expressed as Lman (k). However, when k=0, Lman is expressed with (0) omitted.

Figure 23A and 23B illustrate frequency-gain characteristics of a basic low pass filter L4a4 and basic low pass filter L4a4 (1) generated by inserting one "0" at a time between filter coefficients, Figure 23A expresses the gain on a straight scale and Figure 23B expresses the gain on a logarithmic scale. As is appreciated from this Figure 23, if the number of "0s" tobe inserted between filter coefficients is k, the frequency axis of the frequency-gain characteristic (period with respect to the frequency direction) becomes 1/(k+1) and the bandwidth of the pass band can be narrowed.

### <Cascade connection of basic filters of the same type>

By cascade connecting basic filters of the same type, coefficients of the respective basic filters are multiplied and added up and new filter coefficients are created. When the number of cascade connected basic low pass filters Lman is M, for example, suppose this is descried as (Lman)^{M} below.

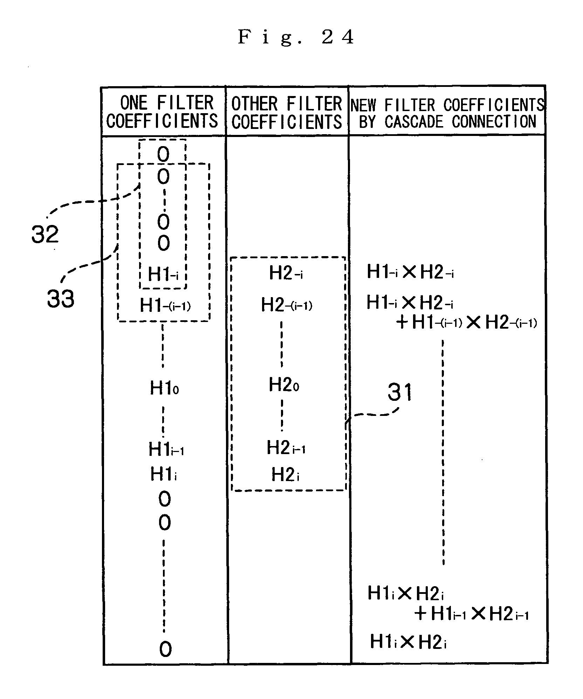

Here, the calculation contents of filter coefficients when the basic filters are cascade connected will be explained. Figure 24 shows calculation contents of filter coefficients in cascade connection. As shown in this Figure 24, when two basic filters are cascade connected, (2i+1) numerical strings {H1₋ᵢ, H1₋₍ᵢ₋₁₎, H1₋₍ᵢ₋₂₎, ..., H1₋₁, H1₀, H1₁, ..., H1ᵢ₋₂, H1ᵢ₋₁, H1ᵢ} making up one filter coefficients (where 2i+1 denotes the total number of numerical strings making up one filter coefficients) and (2i+1) numerical strings {H2₋ᵢ, H2₋₍ᵢ₋₁₎, H2₋₍ᵢ₋₂₎, ..., H2₋₁, H2₀, H2_{1 ...}, H2ᵢ₋₂, H2ᵢ₋₁, H2ᵢ} making up the other filter coefficients are subjected to a convolution to obtain a numerical string of new filter coefficients.

This convolution always targets for a multiplication and addition at all numerical strings of {H2₋ᵢ, H2₋₍ᵢ₋₁₎, H2₋₍ᵢ₋₂₎, ... , H2₋₁, H2₀, H2₁, ..., H2ᵢ₋₂, H2ᵢ₋₁, H2ᵢ} for other filter coefficients fixedly. On the other hand, in the case of the one filter coefficients, assuming that a string of 0s is inserted before and after the numerical string {H1₋ᵢ, H1₋₍ᵢ₋₁₎, H1_{-(I-2)}, ..., H1₋₁, H1₀, H1₁, ..., H1ᵢ₋₂, H1ᵢ₋₁, H1ᵢ}, (2i+1) numerical strings including this 0 value are targeted for a convolution. At this time, when the pth numerical value of the new filter coefficients are calculated, the pth numerical value of the one filter coefficients are calculated and (2i+1) numerical strings which exist ahead of the pth the numerical value are targeted for a multiplication and addition.

For example, when the first numerical value of the new filter coefficients are calculated, including all the numerical strings {H2₋ᵢ, H2₋₍ᵢ₋₁₎, H2₋₍ᵢ₋₂₎, ..., H2₋₁, H2₀, H2₁, ..., H2ᵢ₋₂, H2ᵢ₋₁, H2ᵢ} (array enclosed by dotted line denoted by reference numeral 31) of the other filter coefficients and the first numerical value of the one filter coefficients, (2i+1) numerical strings {0, 0, ..., 0, H1₋ᵢ} (array enclosed by dotted line denotes by reference numeral 32) ahead of them are subj ected to a calculation of adding up the products between the corresponding elements of the array. That is, the calculation result in this case is (H1₋ᵢ×H2₋ᵢ).

Furthermore, when the second numerical value of new filter coefficients are calculated, including all the numerical strings of the other filter coefficients {H2₋ᵢ, H2₋₍ᵢ₋₁₎, H2₋₍ᵢ₋₂₎, ..., H2₋₁, H2₀, H2₁, ..., H2ᵢ₋₂, H2ᵢ₋₁, H2ᵢ} (array enclosed by dotted line denoted by reference numeral 31) and second numerical value of the other filter coefficients, (2i+1) numerical strings {0, 0, ..., 0, H1₋ᵢ, H1₋₍ᵢ₋₁₎} (array enclosed by dotted line denoted by reference numeral 33) ahead of the second numerical value are subjected to a calculation of adding up the products between the corresponding elements of the array. That is, the calculation result in this case is (H1₋ᵢ×H2₋ᵢ+H1₋₍ᵢ₋₁₎×H₂₋₍ᵢ₋₁₎). In the like manner, (2×(2i+1)-1) numerical strings making up the new filter coefficients are obtained.

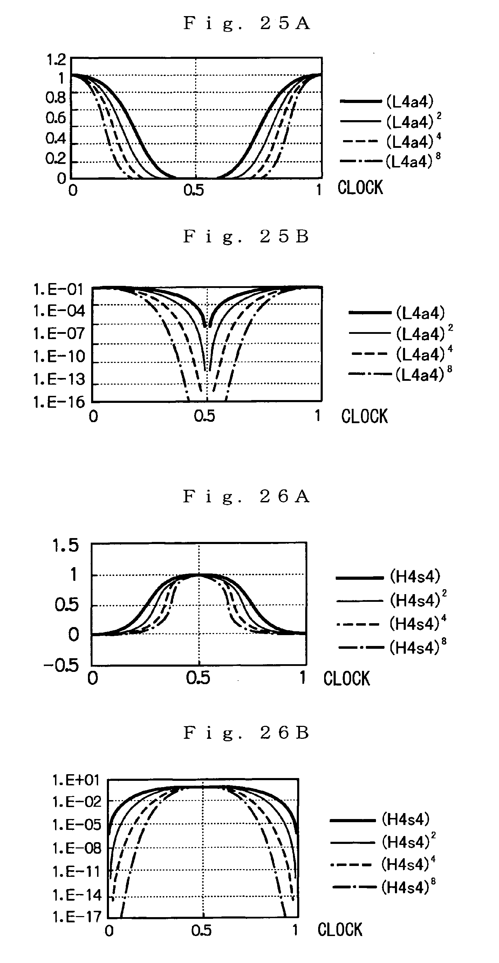

Figure 25A and 25B illustrate frequency-gain characteristics of basic low pass filters L4a4, (L4a4)², (L4a4)⁴, (L4a4)⁸, and Figure 25A expresses the gain on a straight scale and Figure 25B expresses the gain on a logarithmic scale. When there is only one basic low pass filter L4a4, the clock at a position where the amplitude becomes 0.5 is 0.25. On the contrary, when the number of cascade connections M increases, the width of the pass band of the filter becomes narrower. For example, when M=8, the clock at a position where the amplitude becomes 0.5 is 0.125.

As is appreciated from Figure 25, the basic low pass filter L4a4 is characterized in that the inclination of the part peripheral to the cut-off frequency of the frequency characteristic is steep. Furthermore, the frequency-gain characteristic of the basic low pass filter (L4a4)^{M} is characterized in that the pass band width becomes narrower as the number of cascade connections M increases and the characteristic drops straightly to an extreme depth even in a low frequency area.

Figure 26A and 26B illustrate frequency-gain characteristics of basic high pass filters H4s4, (H4s4)², (H4s4)⁴, (H4s4)⁸, Figure 26A expresses the gain on a straight scale and Figure 26B expresses the gain on a logarithmic scale. When there is only one basic high pass filter H4s4, the clock at a position where the amplitude becomes 0.5 is 0.25. On the contrary, when the number of cascade connections M increases, the width of the pass band of the filter becomes narrower. For example, when M=8, the clock at a position where the amplitude becomes 0.5 is 0.375.

As is appreciated from Figure 26, the basic high pass filter H4s4 is characterized in that the inclination of the part peripheral to the cut-off frequency of the frequency characteristic is steep. Furthermore, the frequency-gain characteristic of the basic high pass filter (H4s4)^{M} is characterized in that the pass band width becomes narrower as the number of cascade connections M increases and the characteristic also drops straightly to an extreme depth in a high frequency area.

### <Cascade connection between basic filters of different types>

When basic filters of different types are cascade connected, coefficients of the respective basic filters are also multiplied and added up through a convolution and new filter coefficients are created. In this case, combining basic filters of different types in an arbitrary way causes the characteristics of the respective basic filters to cancel out one another and makes it possible to extract a desired frequency band. This makes it to possible to easily design a low pass filter, high pass filter, band pass filter, band elimination filter, com filter, etc., of a desired characteristic.

### <Rounding of filter coefficients>

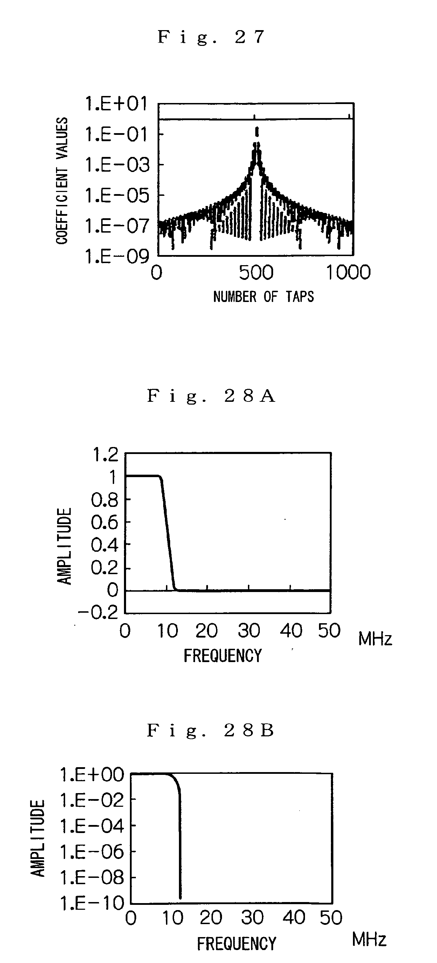

The numerical strings obtained by cascade connections of basic filters and adjustment of bandwidth, etc., become filter coefficients to realize a desired frequency characteristic. Figure 27 shows filter coefficient values (before rounding) actually calculated with 16-bit calculation accuracy in the form of a graph. Furthermore, Figure 28A and 28B illustrate frequency-gain characteristics and frequency-phase characteristic of a digital filter before rounding of filter coefficients, Figure 28A expresses the gain on a straight scale and Figure 28B expresses the gain on a logarithmic scale.

As shown in Figure 27, the value of the filter coefficients obtained using the design method of this embodiment becomes a maximum in the center (coefficient H₀). Furthermore, the difference in the respective filter coefficient values becomes extremely large compared to filter coefficientsobtained using a conventional filter design method. For this reason, even if filter coefficients having a value smaller than a predetermined threshold are discarded by rounding, most of principal filter coefficients which determine the frequency characteristic remain and hardly cause adverse influences on the frequency characteristic. Furthermore, while the attenuation amount out of band of the frequency characteristic is restricted by the number of bits of the filter coefficients, the frequency characteristic obtained by the filter design method of this embodiment as shown in Figure 28 has very deep attenuation, and therefore even if the number of bits is reduced to a certain degree, a desired amount of attenuation can be secured.

Therefore, rounding can drastically reduce unnecessary filter coefficients. For example, by discarding several low-order bits of filter coefficients and thereby reducing the number of bits, it is possible to round all filter coefficients having values smaller than a maximum value expressed by those several low-order bits to "0" and discard them. Therefore, no conventional windowing is necessary to reduce the number of filter coefficients. In this regard, as described above, an impulse response of cascade connected basic filters becomes a finite-base function. Therefore, the number of filter coefficients designed based on these basic filters is smaller than the conventional one, and so the filter coefficients can be used as they are without any rounding. However, it is preferable to carry out rounding for reducing the number of bits to reduce the number of taps.

This is a characteristic point of this embodiment which is considerably different from the conventional filter design method. That is, the difference in values of filter coefficients calculated in the conventional filter design method does not become significantly large, and therefore if rounding is carried out with the values of the filter coefficients, principal filter coefficients which determine the frequency characteristic are also often discarded. Furthermore, since it is difficult to obtain a frequency characteristic having a very deep attenuation amount out of band and if the number of bits of filter coefficients is reduced, it is no longer possible to secure a necessary attenuation amount out of band. Therefore, it has been conventionally impossible to perform rounding to reduce the number of bits and it cannot help but reduce the number of filter coefficients through windowing. For that reason, discretization errors would occur in the frequency characteristic and it has been extremely difficult to obtain a desired frequency characteristic.

In contrast, this embodiment allows filters to be designed without windowing, and so prevents discretization errors from occurring in the frequency characteristic. Therefore, it is possible to improve the cut-off characteristic considerably and obtain excellent filter characteristics with a rectilinear phase characteristic.

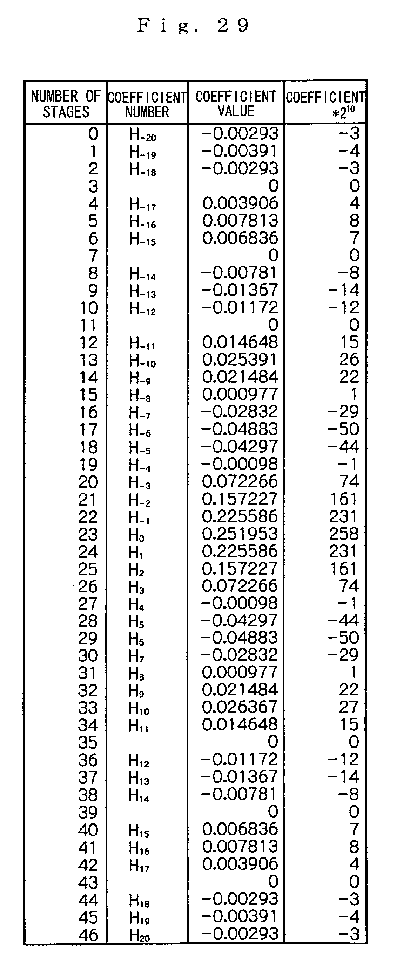

Figure 29 illustrates filter coefficient values corresponding to 41 taps (the number of stages including zero value is 46) remaining as a result of 10-bit rounding on the filter coefficients as shown in Figure 27 calculated with 16-bit calculation accuracy and their corresponding coefficient values rounded to integers. The values of filter coefficients calculated through cascade connections of the above described basic filters are decimal fractions and the number of their digits can be reduced through 10-bit rounding, but they are a set of random values. Though this numerical string may be used as filter coefficients as are, it is also possible to further round the numerical values of the filter coefficients to reduce the number of multipliers used to mount a digital filter and simplify the digital filter. For this purpose, this embodiment multiplies the numerical string of the filter coefficients subjected to 10-bit rounding 2¹⁰-fold, rounds their decimal fractions and rounds the coefficient values to integers.

If such rounding to integers is performed, it is possible to individually multiply integer filter coefficients with respect to output signals from the respective taps of the digital filter, add up all multiplication outputs and then multiply them all together 1/2¹⁰-fold to construct a digital filter. Moreover, integer filter coefficients can be expressed by additions of binary numbers such as 2ⁱ+2^{j}+ ... (i, j are arbitrary integers). This makes it possible to construct a coefficient unit with bit shift circuits instead of multipliers and thereby simplify the structure of a digital filter mounted.

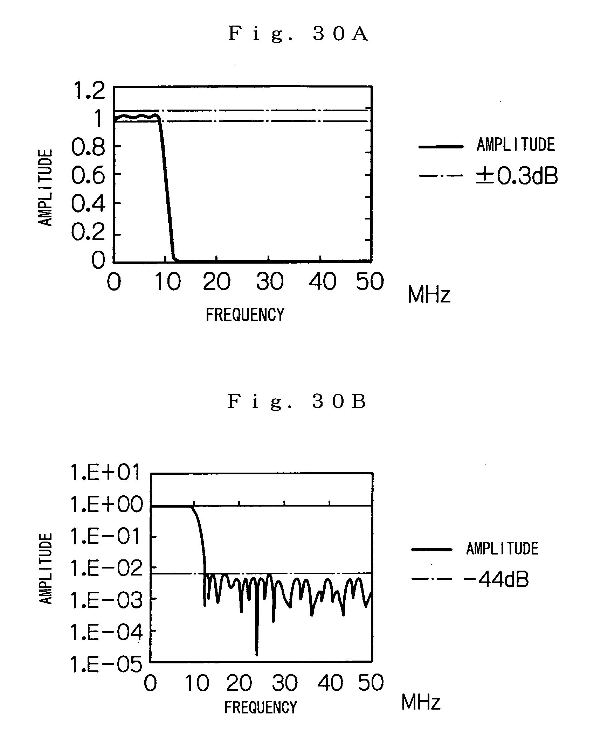

Figure 30A and 30B illustrate frequency-gain characteristics after calculating filter coefficients with 16-bit calculation accuracy, rounding the filter coefficients to a 10-bit number (discarding all digits below the 10-bit number) and further rounding it to an integer, Figure 30A expresses the gain on a straight scale and Figure 30B expresses the gain on a logarithmic scale.

As is appreciated clearly from Figure 30, when designing a filter, this embodiment does not perform any windowing, causing ripples in the flat part of the frequency-gain characteristic to become extremely small, sufficiently falling within a range of ±0.3 dB. Furthermore, the attenuation amount out of band after rounding is approximately 44 dB, but this attenuation amount out of band is restricted by the number of bits that can be implemented by hardware to be mounted. Therefore, unless there are restrictions on the scale of hardware, it is possible to increase the number of bits after rounding and obtain a deeper out-of-band attenuation characteristic.

Here, as an example of rounding, processing of rounding y-bit data to x bits by discarding several low-order bits from filter coefficient data has been explained, but the present invention is not limited to this example. For example, it is also possible to compare values of respective filter coefficients with a predetermined threshold and discard filter coefficients smaller than the threshold. In this case, since the remaining filter coefficients continue to have the original y bits, the filter coefficients are multiplied 2^{y}-fold to be rounded to integers.

### <Mounting example of filter design device>

The device for realizing the design method of the digital filter according to this embodiment described above can be implemented by a hardware structure, DSP or any software. For example, when the device is implemented by software, the filter design device of this embodiment is actually constructed of a CPU of a computer or MPU, RAM, ROM, and can be implemented by a program stored in the RAM, ROM or a hard disk, etc.

For example, filter coefficients related to various types of basic filters Lman, Lan, Hmsn, Hsn, Bmsn and Bsn are stored in a storage device such as RAM, ROM or hard disk, etc. as data. Then, when the user instructs an arbitrary combination related to the basic filters Lman, Lan, Hmsn, Hsn, Bmsn and Bsn, connection order, the number of zero values k to be inserted between filter coefficients or the number of cascade connected basic filters of the same type M, etc. , it is possible to cause the CPU to use data of filter coefficients stored in the above described storage device and obtain the filter coefficients corresponding to the instructed contents through the above described calculation. In this case, the storage device corresponds to the basic filter coefficient storage means of the present invention and the CPU corresponds to the calculation means of the present invention.

The user interface used by the user to instruct the combination related to the basic filters Lman, Lan, Hmsn, Hsn, Bmsn and Bsn, the connection order, number of zero values k to be inserted or the number of cascade connections M, etc., can be constructed in an arbitrary way. For example, it is possible to allow the user to select the type of the basic filter (any one of Lman, Lan, Hmsn, Hsn, Bmsn, Bsn) from a list shown on the screen by operating a keyboard or mouse and input values of parameters m, n, k, M through operation of the keyboard or mouse. Then, the input order in which a type is selected and parameters are input one by one is input as the connection order of basic filters. The CPU acquires the information input in this way and obtains filter coefficients corresponding to the contents instructed by the input information through the above described calculations.

Furthermore, various types of basic filters Lman, Lan, Hmsn, Hsn, Bmsn and Bsn are iconized and displayed on a display screen (filter coefficients are stored in a storage device as data in a one-to-one correspondence with icons) and the user combines these icons on the display screen in an arbitrary way by operating the keyboard or mouse and arranges the icons on the display screen. Furthermore, other necessary parameters are input by operating the keyboard or mouse. It is also possible to cause the CPU to automatically calculate and acquire filter coefficients corresponding to an arrangement of icons and input parameters.

Furthermore, it is also possible to carry out a moving average calculation when obtaining basic filters and a convolution, etc., when cascade connecting the basic filters using the function features of a spreadsheet installed in a personal computer, etc. The calculation in this case is performed by the CPU, ROM, RAM, etc. , of the personal computer in which the spreadsheet software is installed.

Furthermore, it is also possible to automatically FFT transform the filter coefficients obtained and display the result on the display screen as a frequency-gain characteristic diagram. By so doing, it is possible to visually confirm the frequency characteristic of the designed filter and design the filter more easily.

### <Mounting example of digital filter>

When a digital filter is actually mounted in an electronic device or semiconductor IC, it is possible to construct an FIR filter having the numerical string finally determined by the above described filter design device as filter coefficients. That is, one digital filter is constructed of a plurality of D-type flip flops, a plurality of coefficient units and a plurality of adders in such a way that the final filter coefficients calculated in the above described procedure are set in a plurality of coefficient units in the digital filter.

In that case, the number of filter coefficients obtained has been reduced drastically by 10-bit rounding and the filter coefficients have been converted to simple integers through 2¹⁰-fold rounding. Therefore, there are a very small number of taps, multipliers are basically unnecessary and replaceable by a bit shift circuit, and it is possible to realize a desired frequency characteristic on a small circuit scale and with high accuracy.

Furthermore, of the basic filters Lman (k), Lan (k), Hmsn (k), Hsn (k), Bmsn (k) and Bsn (k), it is also possible to construct the basic filters used to design the filter as hardware and connect those basic filters as hardware to thereby mount a digital filter. Examples of the hardware structures of the basic filters Lman, Lan, Hmsn, Hsn, Bmsn and Bsn will be shown below.

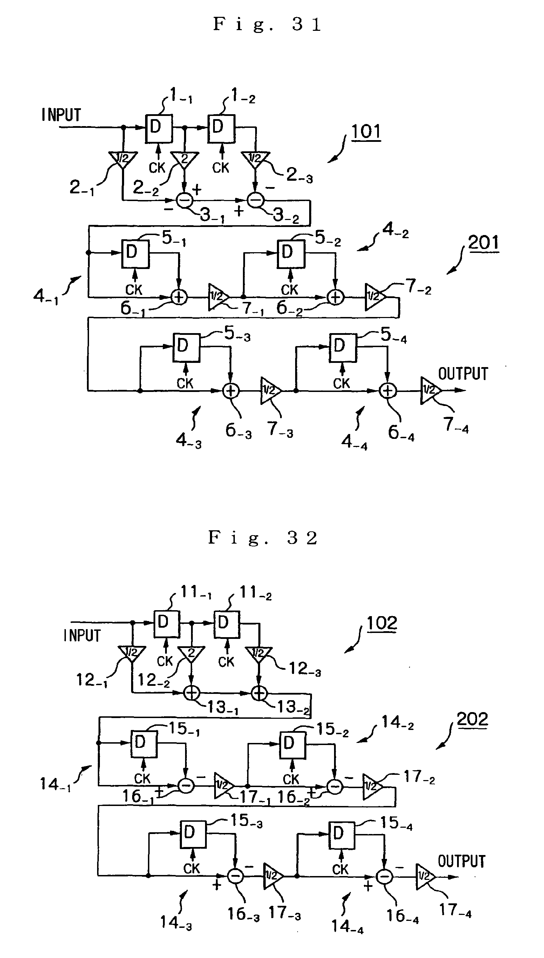

Figure 31 illustrates an example of the hardware structure of the basic low pass filter L4a4 (when m=4, n=4). As shown in Figure 31, the basic low pass filter L4a4 is constructed by including an FIR calculation section 101 which has a numerical string "-1/2, 2, -1/2" which becomes a starting point as filter coefficients and a moving average calculation section 201 which applies the moving average calculation to the numerical string. Of these sections, the FIR calculation section 101 is constructed of two cascade connected D-type flip flops 1₋₁ and 1₋₂, three coefficient units 2₋₁ to 2₋₃ and two subtractors 3₋₁ and 3₋₂.

The two D-type flip flops 1₋₁ and 1₋₂ sequentially delay input data by 1 clock CK at a time. The three coefficient units 2₋₁ to 2₋₃ multiply the signals extracted from the input/output taps of the D-type flip flops 1₋₁ and 1₋₂ by filter coefficients of 1/2, 2, 1/2, respectively. The first subtractor 3₋₁ subtracts a multiplication result of the first coefficient unit 2₋₁ from a multiplication result of the second coefficient unit 2₋₂. Furthermore, the second subtractor 3₋₂ subtracts a multiplication result of third coefficient unit 2₋₃ from a subtraction result of the first subtractor 3₋₁.

Furthermore, the moving average calculation section 201 is constructed by cascade connecting four integrators 4₋₁ to 4₋₄ of the same structure. For example, the integrator 4₋₁ in the first stage is constructed of a D-type flip flop 5₋₁ that delays input data by 1 clock, an adder 6₋₁ that adds up original data which does not pass through the D-type flip flop 5₋₁ and preceding data which has been delayed by passing through the D-type flip flop 5₋₁ and an adjuster 7₋₁ for restoring the amplitude of the addition result.

According to the structure of the basic low pass filter L4a4 shown in this Figure 31, it is only the FIR calculation section 101 in the first stage that requires coefficient units 2₋₁ to 2₋₃ that multiply data by filter coefficients and output taps which are output ports of data for the coefficient units 2₋₁ to 2₋₃. Moreover, the number of the coefficient units and output taps is only three.

Moreover, since the values of the filter coefficients are 1/2, 2, 1/2, the coefficient units 2₋₁ to 2₋₃ can be constructed of bit shift circuits. Furthermore, the adjusters 7₋₁ to 7₋₄ provided for the four integrators 4₋₁ to 4₋₄ can also be constructed of bit shift circuits. Even when the value of n is other than 4 and the number of adjusters is changed, all the adjusters can be constructed of bit shift circuits. Thus, no multiplier is required in the hardware structure of a basic low pass filter L4an.

Here, the case with m=4 has been explained, but if m=2ⁱ (i is an integer), all the coefficient units and adjusters can be constructed of bit shift circuits and no multiplier is required.

Figure 32 illustrates the hardware structure of the basic low pass filter La4 (when n=4). Here, since the numerical string which is a starting point is single "1", the two D-type flip flop 1₋₁ and 1₋₂, three coefficient units 2₋₁ to 2₋₃ and two subtractors 3₋₁ and 3₋₂ shown in Figure 31 are not necessary. That is, it is possible to construct the basic low pass filter La4 by only cascade connecting the four integrators 4₋₁ to 4₋₄ of the latter half of the filter shown in Figure 31. Therefore, the number of taps is 0 and no multiplier is required at all.

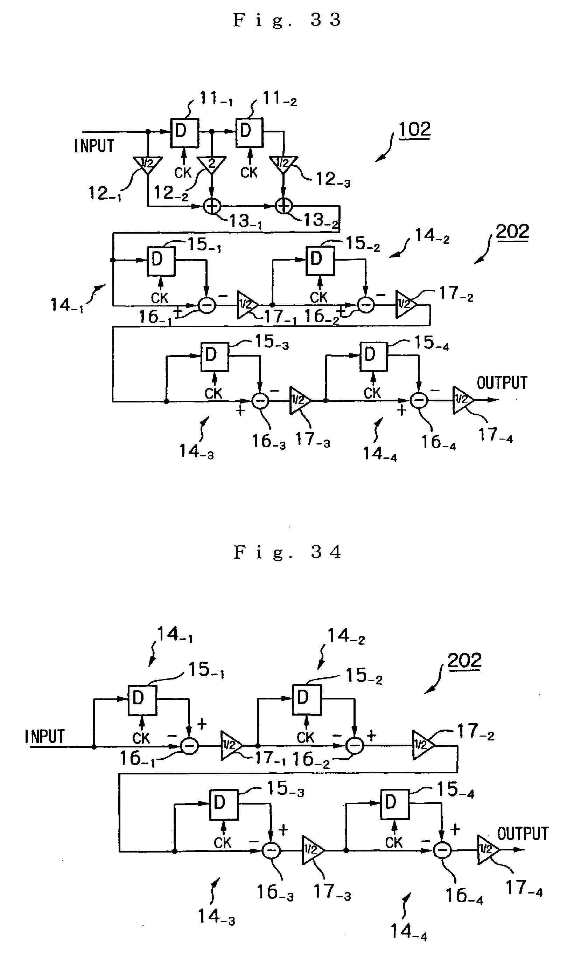

Figure 33 illustrates the hardware structure of the basic high pass filter H4s4 (when m=4, n=4). As shown in Figure 33, the basic high pass filter H4s4 is constructed by including an FIR calculation section 102 that has a numerical string "1/2, 2, 1/2" as filter coefficients to be a starting point and a moving average calculation section 202 that performs a moving average calculation on the numerical string. Of the two sections, the FIR calculation section 102 is constructed of two cascade connected D-type flip flops 11₋₁ and 11₋₂, three coefficient units 12₋₁ to 12₋₃ and two adders 13₋₁ and 13₋₂.

The two D-type flip flops 11₋₁ and 11₋₂ delay input data sequentially by 1 clock CK at a time. The three coefficient units 12₋₁ to 12₋₃ multiply signals extracted from the input/output taps of the D-type flip flops 11₋₁ and 11₋₂ by filter coefficients of 1/2, 2, 1/2 respectively. The two adders 13₋₁ and 13₋₂ add up all the multiplication results of the coefficient units 12₋₁ to 12₋₃ and output the addition results.

Furthermore, the moving average calculation section 202 is constructed by cascade connecting four differentiators 14₋₁ to 14₋₄ of the same structure. For example, the differentiator 14₋₁ in the first stage is constructed of a D-type flip flop 15₋₁ that delays input data by 1 clock, a subtractor 16₋₁ that subtracts preceding data which has been delayed by passing through the D-type flip flop 15₋₁ from original data which does not pass through the D-type flip flop 15₋₁ and an adjuster 17₋₁ for restoring the amplitude of the subtraction result.

According to the structure of the basic high pass filter H4s4 shown in this Figure 33, it is only the FIR calculation section 102 in the first stage that requires coefficient units 12₋₁ to 12₋₃ that multiply data by the filter coefficients and output taps which are output ports of data for the coefficient units 12₋₁ to 12₋₃. Moreover, the number of the coefficient units and output taps is only three.

Moreover, since the values of the filter coefficient are 1/2, 2, 1/2, the coefficient units 12₋₁ to 12₋₃ can be constructed of bit shift circuits. Furthermore, the adjusters 17₋₁ to 17₋₄ provided for the four differentiators 14₋₁ to 14₋₄ can also be constructed of bit shift circuits. Even when the value of n is other than 4 and the number of adjusters is changed, all the adjusters can be constructed of bit shift circuits. Thus, no multiplier is required in the hardware structure of the basic high pass filter H4sn, either.

Here, the case with m=4 has been explained, but if m=2ⁱ (i is an integer), all coefficient units and adjusters can be constructed of bit shift circuits and no multiplier is required.

Figure 34 illustrates the hardware structure of the basic high pass filter Hs4 (when n=4). Here, since the numerical string which is a starting point is single "1", the two D-type flip flops 11₋₁ and 11₋₂, three coefficient units 12₋₁ to 12₋₃ and two subtractors 13₋₁ and 13₋₂ shown in Figure 33 are not necessary. That is, it is possible to construct the basic high pass filter Hs4 by only cascade connecting the four integrators 14₋₁ to 14₋₄ of the latter half of the filter shown in Figure 33. Therefore, the number of taps is 0 and no multiplier is required at all.

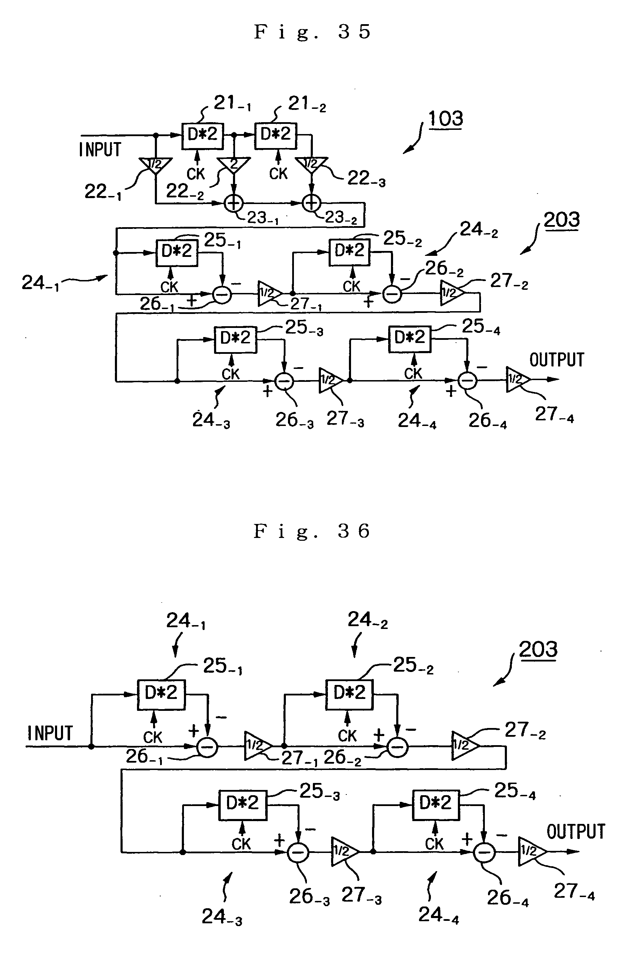

Figure 35 illustrates the hardware structure of the basic band pass filter B4s4 (when m=4, n=4). As shown in Figure 35, the basic band pass filter B4s4 is constructed by including an FIR calculation section 103 that has a numerical string "1/2, 0, 2, 0, 1/2" as filter coefficients to be a starting point and a moving average calculation section 203 that performs a moving average calculation on the numerical string. Of the two sections, the FIR calculation section 103 is constructed of two cascade connected D-type flip flops 21₋₁ and 21₋₂, three coefficient units 22₋₁ to 22₋₃ and two adders 23₋₁ and 23₋₂.

The two D-type flip flops 21₋₁ and 21₋₂ delay input data sequentially by 2 clocks CK at a time. The three coefficient units 22₋₁ to 22₋₃ multiply signals extracted from the input/output taps of the D-type flip flops 21₋₁ and 21₋₂ by filter coefficients of 1/2, 2, 1/2 respectively. The two adders 23₋₁ and 23₋₂ add up all the multiplication results of the coefficient units 22₋₁ to 22₋₃ and output the addition results.

Furthermore, the moving average calculation section 203 is constructed by cascade connecting four differentiators 24₋₁ to 24₋₄ of the same structure. For example, the differentiator 24₋₁ in the first stage is constructed of a D-type flip flop 25₋₁ that delays input data by 2 clocks, a subtractor 26₋₁ that subtracts preceding data which has been delayed by passing through the D-type flip flop 25₋₁ from original data which does not pass through the D-type flip flop 25₋₁ and an adjuster 27₋₁ for restoring the amplitude of the subtraction result.

According to the structure of the basic band pass filter B4s4 shown in this Figure 35, it is only the FIR calculation section 102 in the first stage that requires the coefficient units 22₋₁ to 22₋₃ that multiply data by the filter coefficients and output taps which are output ports of data for the coefficient units 22₋₁ to 22₋₃. Moreover, the number of the coefficient units and output taps is only three.

Moreover, since the values of the filter coefficient are 1/2, 2, 1/2, the coefficient units 22₋₁ to 22₋₃ can be constructed of bit shift circuits. Furthermore, the adjusters 27₋₁ to 27₋₄ provided for the four differentiators 24₋₁ to 24₋₄ can also be constructed of bit shift circuits. Even when the value of n is other than 4 and the number of adjusters is changed, all the adjusters can be constructed of bit shift circuits. Thus, no multiplier is required in the hardware structure of the basic band pass filter B4sn, either.

Here, the case with m=4 has been explained, but if m=2ⁱ (i is an integer), all the coefficient units and adjusters can be constructed of bit shift circuits and no multiplier is required.

Figure 36 illustrates the hardware structure of the basic band pass filter Bs4 (when n=4). Here, since the numerical string which is a starting point is single "1", the two D-type flip flops 21₋₁ and 21₋₂, three coefficient units 22₋₁ to 22₋₃ and two adders 23₋₁ and 23₋₂ shown in Figure 35 are not necessary. That is, it is possible to construct the basic band pass filter Bs4 by only cascade connecting the four differentiators 24₋₁ to 24₋₄ of the latter half of the filter shown in Figure 35. Therefore, the number of taps is 0 and no multiplier is required at all.

### <Design example of digital filter>

Next, design examples of a digital filter using the above described basic filter will be explained below. Here, a case where a band pass filter satisfying the following target specifications is designed will be explained as an example:
Central frequency: 450 KHz
Sampling frequency: 1.8 MHz
Attenuation amount out of band: -80 dB
-3 dB bandwidth: 10 KHz

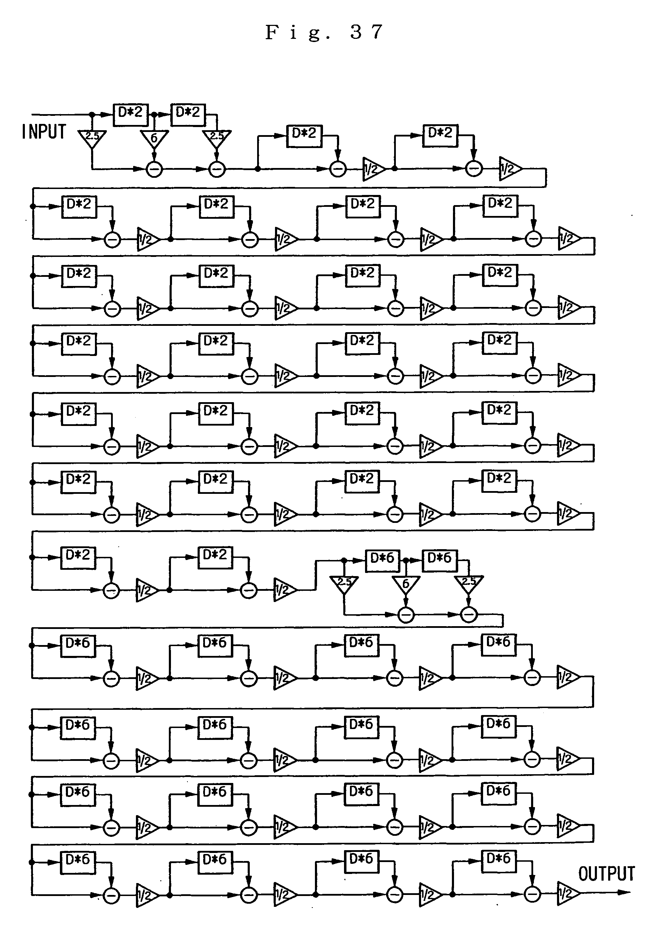

Figure 37 illustrates an example of the circuit structure of a band pass filter which realizes the above described target specifications. This band pass filter is constructed by cascade connecting a basic high pass filter H2.4s24 (2) and basic high pass filter H2.4s16 (6). When a plurality of basic filters are combined appropriately and cascade connected, their respective characteristic values cancel each other out, frequency bands are extracted and it is thereby possible to realize a desired frequency characteristic.

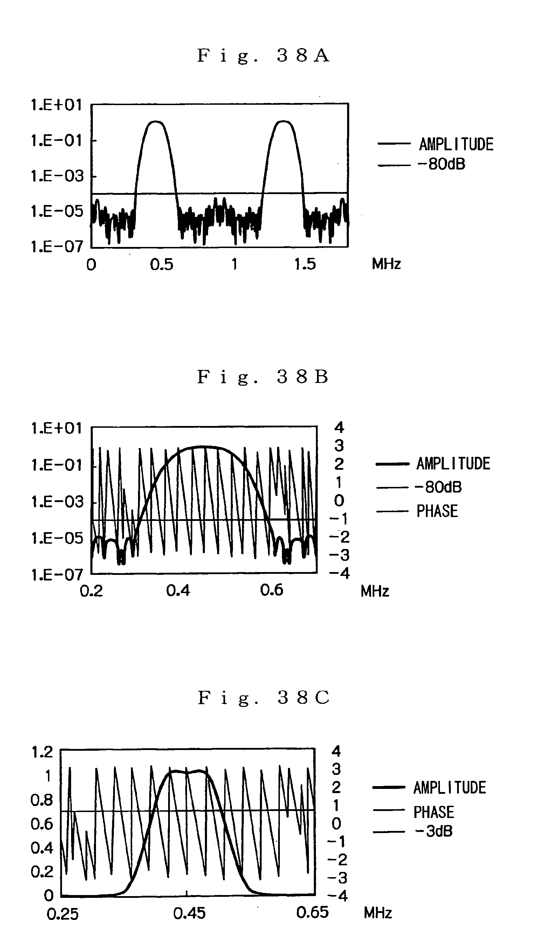

Figure 38A to 38C illustrate frequency characteristics of the band pass filter constructed as shown in Figure 37, Figure 38A shows an overall characteristic expressing the gain on a logarithmic scale, Figure 38B shows a partially enlarged characteristic expressing the gain on a logarithmic scale and Figure 38C shows a partially enlarged characteristic expressing the gain on a straight scale. As is appreciated from this Figure 38, the band pass filter in Figure 37 satisfies the target specifications.

The band pass filter shown in Figure 38 requires only 6 taps. Furthermore, since the coefficient unit at each tap output can be constructed of a bit shift circuit (2.5=2+1/2,6=4+2), no multiplier is required. Moreover, it is possible to obtain a band pass filter having a desired characteristic in an extremely simple structure made up of repetition of substantially the same circuit.

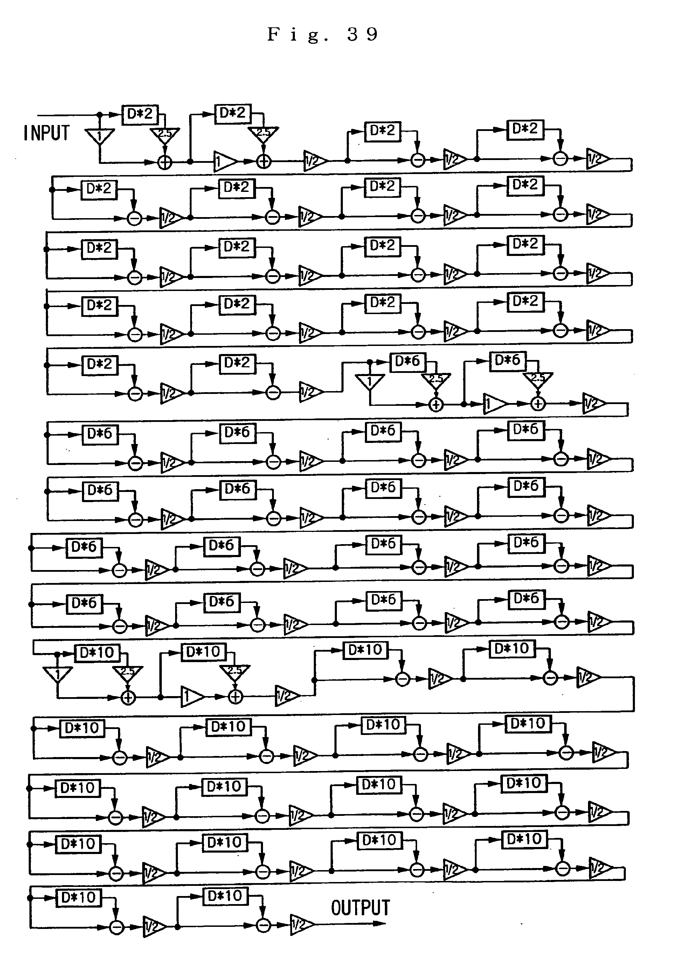

Figure 39 illustrates another example of the structure of a band pass filter that satisfies the following target specifications:
Central frequency: 450 KHz
Sampling frequency: 1.8 MHz
Attenuation amount out of band: -80 dB
-3dB bandwidth: 40 KHz

The band pass filter shown in Figure 39 is constructed by cascade connecting a basic band pass filter B2.9s16 (2), basic band pass filter B2.9s16 (6) and basic band pass filter B2.9s16 (10). m=2. 9 corresponds to N=2. 5 when viewed in terms of basic unit filter coefficients "1, 0, N." Thus, the basic band pass filter B2.9s16 is constructed by cascade connecting two basic unit filters having coefficient values which can be realized by bit shifts.

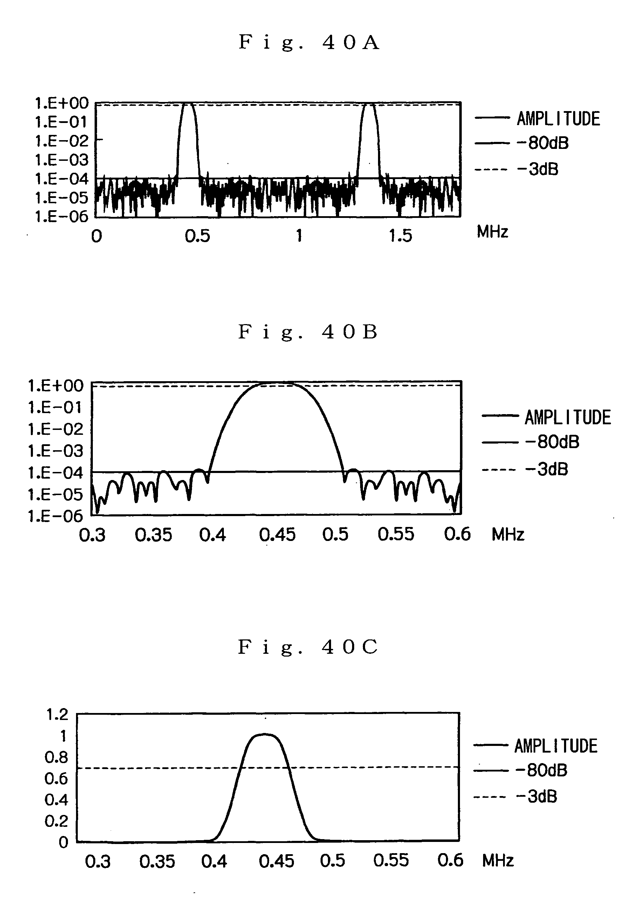

Figure 40A to 40C illustrate frequency-gain characteristics of the band pass filter constructed as shown in Figure 39, Figure 40A shows an overall characteristic expressing the gain on a logarithmic scale, Figure 40B shows a partially enlarged characteristic expressing the gain on a logarithmic scale and Figure 40C shows a partially enlarged characteristic expressing the gain on a straight scale. As is appreciated from this Figure 40, the band pass filter in Figure 39 satisfies the target specifications.

The example in Figure 39 also shows a 1× coefficient unit, but this is substantially not necessary. The number of taps necessary for the band pass filter shown in Figure 39 is therefore only 6. Furthermore, the coefficient unit at each tap output can be constructed of a bit shift circuit, and therefore no multiplier is required. Moreover, it is possible to obtain a band pass filter of a desired characteristic in an extremely simple structure made up of repetition of substantially the same circuit.

Here, only a design example of the band pass filter is shown, but it is also possible to easily design a low pass filter, high pass filter, band elimination filter and com filter, etc., having desired characteristics using the same technique by changing the way to combine basic filters.

As explained in detail above, this embodiment uses a numerical string obtained by cascade connecting an even number of basic unit filters whose filter coefficients consist of a numerical string "1, N" or "-1, N" as a starting point, carries out moving average calculations n times, thereby generates a basic filter and designs a digital filter having a desired frequency characteristic by combining at least one basic filter in an arbitrary way, and can thereby have the following merits :
(1) It is possible to drastically reduce the number of taps compared to a conventional FIR filter. Furthermore, no multiplier is required. Most of the structure is made up of D-type flip flops and adders/subtractors. Therefore, it is possible to drastically reduce the number of circuit elements and reduce the circuit scale, reduce power consumption and reduce calculation loads, etc.
(2) When a digital filter is mounted in the formof hardware which cascade connects individual basic filters, the number of taps required for the individual basic filters is only 1 to 3 and all filter coefficients necessary for each tap output have simple numerical values and there are not many types. Moreover, it has an extremely simple structure made up of repetition of the same pattern, and can thereby reduce the number of man hours for integration and facilitate integration on an IC chip.
(3) The individual basic filters basically require no multiplier and require no DSP in creating a digital filter.
(4) A digital filter can be constructed by only combining basic filters and the design consists of combining frequency characteristics on the actual frequency axis. Therefore, the filter design is simple and easy to be thought of, allowing even non-skilled technician to perform a filter design extremely simply and sensuously.
(5) The impulse response of a basic filter is a finite-base function, which does not require windowing in the conventional art. The ability to design a filter without windowing prevents discretization errors from occurring in the frequency characteristic. Therefore, it is possible to improve the cut-off characteristic considerably and also provide an excellent filter characteristic with a rectilinear phase characteristic.
(6) The attenuation amount out of band is restricted by the number of bits of hardware. Therefore, it is possible to obtain a substantially uniform out-of-band attenuation characteristic with deep attenuation.
(7) Even when a numerical string calculated by combining at least one basic filter in an arbitrary way and cascade connecting them is mounted in a digital filter as filter coefficients, it is possible to drastically reduce the number of taps compared with a conventional FIR filter by drastically reducing unnecessary filter coefficients through rounding. Furthermore, rounding the filter coefficients to integers allows a coefficient unit at each tap output to be constructed of a bit shift circuit, which eliminates the necessity for multipliers and drastically reduces the number of circuit elements and reduces the circuit scale.

The above described embodiment has explained examples in Figure 4, Figure 10 and Figure 16 where a moving average calculation is performed taking "1" as a starting point, but "-1" can also be taken as the starting point. When "-1" is taken as the starting point, the phase characteristic is only shifted by π and the frequency characteristic remains unchanged.

Furthermore, the above described embodiment has explained the case where an FIR calculation section is constructed by cascade connecting two basic unit filters, but it is also possible to construct an FIR calculation section by an even number of connections other than 2 such as 4, 6, 8, ....

In addition, the above described embodiment has merely explained examples of implementation of the present invention and the technological scope of the present invention should not be interpreted limited to the embodiment. That is, the present invention can be implemented in various forms without departing from the spirit of the present invention or major features thereof.

### [Industrial Applicability]

The present invention is suitable for use in a type of an FIR digital filter provided with a tapped delay line made up of a plurality of delayers, wherein output signals of the respective taps are multiplied several-fold by filter coefficients respectively and their multiplication results are added up and output.

## Claims

1. A digital filter design method comprising the steps of:
calculating filter coefficients when at least one FIR type basic filter having basic filter coefficients is combined in an arbitrary way and cascade connected; and
determining the calculated filter coefficients as filter coefficients of the digital filter to be obtained,
said basic filter coefficients consist of at least one of a numerical string of following (1) or (2),
(1) a numerical string obtained by subjecting a numerical string consisting of a ratio of "-1, m, -1" to a moving average calculation n times, said moving average calculation is operated by adding up original data before the calculation and preceding data ahead of the original data by a predetermined amount of delay and outputting the addition result with adjusting the amplitudes,
(2) a numerical string obtained by subjecting a numerical string consisting of a ratio of "1, m, 1" to a moving average calculation n times, said moving average calculation is operated by subtracting preceding data ahead of the original data by a predetermined amount of delay from the original data before the calculation and outputting the subtraction result with adjusting the amplitudes.

2. The digital filter design method according to claim 1,
several zero values are inserted between respective numerical values of a numerical string consisting of a ratio of "-1, m, -1" or "1, m, 1" or said numerical string subjected to said moving average calculation n times to thereby adjust frequency pass bands of the filter.

3. The digital filter design method according to claim 1,
said numerical string consisting of a ratio of "-1, m, -1" corresponds to said numerical string of "-1, m, -1" multiplied 1/(m-2)-fold.

4. The digital filter design method according to claim 1,
said numerical string consisting of a ratio of "1, m, 1" corresponds to said numerical string of "1, m, 1" multiplied 1/(m-2)-fold.

5. The digital filter design method according to claim 1,
said number of times n said moving average calculation is repeated is 8/(m-2).

6. The digital filter design method according to claim 5,
the value of said m is a value that satisfies a condition of 2<m≤10.

7. The digital filter design method according to claim 1,
y-bit filter coefficients which are calculation result when said basic filters are combined in an arbitrary way and cascade connected are subjected to rounding of discarding several low-order bits to thereby obtain x-bit (x<y) filter coefficients.

8. The digital filter design method according to claim 7,
the x-bit filter coefficients obtained by said rounding are subjected to second rounding of multiplying 2^{x}-fold said x-bit filter coefficients and rounding the decimal fractions so as to round the filter coefficients to an integer.

9. A digital filter design device comprising:
basic filter coefficient storage means for storing data related to basic filter coefficients made up of a numerical string obtained by subjecting a numerical string consisting of a ratio of "-1, m, -1" to a moving average calculation n times by adding up original data before the calculation and preceding data ahead of the original data by a predetermined amount of delay and outputting the addition result with adjusting the amplitudes and basic filter coefficients made up of a numerical string obtained by subjecting a numerical string consisting of a ratio of "1, m, 1" to a moving average calculation n times by subtracting preceding data ahead of the original data by a predetermined amount of delay from the original data before the calculation and outputting the subtraction result with adjusting the amplitudes; and
calculation means for calculating filter coefficients when at least one FIR type basic filter having said basic filter coefficients is combined in an arbitrary way and cascade connected using the data stored in said basic filter coefficient storage means.

10. The digital filter design device according to claim 9,
said calculation means further comprises means for obtaining x-bit (x<y) filter coefficients by subjecting y-bit filter coefficients which are calculation result when said basic filters are combined in an arbitrary way and cascade connected to rounding of discarding several low-order bits.

11. The digital filter design device according to claim 10,
said calculation means further comprises means for subjecting the x-bit filter coefficients obtained by said rounding to second rounding of multiplying 2^{x}-fold the x-bit filter coefficients and rounding the decimal fractions so as to round the filter coefficients to an integer.

12. A digital filter design program for causing a computer to execute the processing steps related to the digital filter design method according to any one of claims 1 to 8.

13. A digital filter design program for causing a computer to function as the means according to any one of claims 9 to 11.

14. An FIR type digital filter having a numerical string calculated using the design method according to any one of claims 1 to 8 or using the design device according to any one of claims 9 to 11 as filter coefficients.

15. A digital filter comprising a tapped delay line made up of a plurality of delayers, output signals of the respective taps are multiplied several-fold by filter coefficients obtained using the design method according to any one of claims 1 to 8 or the design device according to any one of claims 9 to 11, the multiplication results are added up and output.

16. A digital filter comprising:
an FIR calculation section that multiplies output data of respective taps of a tapped delay line made up of a plurality of delayers several-fold by filter coefficients made up of a numerical string consisting of a ratio of "-1, m, -1", adds up the multiplication results and outputs the addition result; and
a moving average calculation section that subjects output data of said FIR calculation section to a moving average calculation n times by adding up original data before the calculation and preceding data ahead of the original data by a predetermined amount of delay and outputting the addition result with adjusting the amplitudes.

17. A digital filter comprising:
an FIR calculation section that multiplies output data of respective taps of a tapped delay line made up of a plurality of delayers several-fold by filter coefficients made up of a numerical string consisting of a ratio of "1, m, 1", adds up the multiplication results and outputs the addition result; and
a moving average calculation section that subjects output data of said FIR calculation section to a moving average calculation n times by subtracting preceding data ahead of original data by a predetermined amount of delay from the original data before the calculation and outputting the subtraction result with adjusting the amplitudes.

18. A digital filter comprising:
an FIR calculation section made up of an even number of cascade connected basic unit filters, constructed so that said basic unit filters multiply output data of the respective taps of a tapped delay line made up of a plurality of delayers several-fold by filter coefficients made up of a numerical string consisting of a ratio of "-1, N", adding up the multiplication results and outputting the addition result; and
a moving average calculation section that subj ects output data of said FIR calculation section to a moving average calculation n times by adding up original data before the calculation and preceding data ahead of the original data by a predetermined amount of delay and outputting the addition result with adjusting the amplitudes.

19. A digital filter comprising:
an FIR calculation section made up of an even number of cascade connected basic unit filters, constructed so that said basic unit filters multiply output data of the respective taps of a tapped delay line made up of a plurality of delayers several-fold by filter coefficients made up of a numerical string consisting of a ratio of "1, N", adding up the multiplication results and outputting the addition result; and
a moving average calculation section that subj ects output data of said FIR calculation section to a moving average calculation n times by subtracting preceding data ahead of original data by a predetermined amount of delay from the original data before the calculation and outputting the subtraction result with adjusting the amplitudes.

20. The digital filter according to claim 18 or 19,
said value of N is 0, a filter coefficients of said FIR calculation section made up of an even number of cascade connected basic unit filters is "1"

21. The digital filter according to any one of claims 16 to 20,
delay intervals of delayers making up said FIR calculation section and delay intervals of delayers making up said moving average calculation section are set to a predetermined amount.

22. A digital filter comprising:
the digital filter according to claim 18, the digital filter according to claim 19, and the digital filter according to claim 18 or 19 for which delay intervals of delayers making up said FIR calculation section and delay intervals of delayers making up said moving average calculation section are set to a predetermined amount are used as basic filters and at least one basic filter is combined in an arbitrary way and cascade connected.

23. The digital filter according to claim 16,
said numerical string consisting of a ratio of "-1, m, -1" corresponds to said numerical string of "-1, m, -1" multiplied 1/(m-2)-fold.

24. The digital filter according to claim 17,
said numerical string consisting of a ratio of "1, m, 1" corresponds to said numerical string of "1, m, 1" multiplied 1/(m-2)-fold.

25. The digital filter according to claim 16 or 17,
the number of times n said moving average calculation is repeated is 8/(m-2).

26. The digital filter according to claim 25,
the value of said m is a value that satisfies a condition of 2<m≤10.
